# EUROPEAN PATENT APPLICATION

(11) **EP 4 618 152 A1**
(43) Date of publication of application: **17.09.2025**
(21) Application number: 25154307.0
(22) Date of filing: 28.01.2025
(51) Int. Cl.: H01L 25/065, H01L 25/00, H01L 21/56, H01L 23/31, H01L 23/367, H01L 23/48, H01L 23/00, H01L 25/18

(54) **3D DIE STACK REDISTRIBUTION LAYER FOR TOPSIDE POWER DELIVERY TO BACKSIDE DIE METALLIZATION IN MULTICHIP COMPOSITE DEVICES**

(30) Priority: 15.03.2024 US 202418607259
(71) Applicant: Intel Corporation, Santa Clara, CA 95054 (US)
(72) Inventor: WALCEZYK, Joe, Tigard, 97224 (US); MAHAJAN, Ravindranath, Chandler, 85248 (US); RADHAKRISHNAN, Kaladhar, Chandler, 85226 (US); TADAYON, Pooya, Portland, 97225 (US); MOREIN, Stephen, San Jose (US); KARHADE, Omkar, Chandler, 85248 (US); AGRAHARAM, Sairam, Chandler, 85286 (US); DHALL, Ashish, Chandler, 85248 (US); PAHLANI, Gunjan, Chandler, 85226 (US); SAWYER, Holly, Aloha, 97007 (US)
(74) Representative: Goddar, Heinz J.

(57) **Abstract**

Microelectronic devices, assemblies, and systems include a multichip architecture having one or more integrated circuit dies over and bonded to a base die, and a metallization network over the integrated circuit die(s). A backside metallization of the integrated circuit die(s) is proximal to the metallization network and a frontside metallization of the integrated circuit die(s) is opposite a device layer from the backside metallization. A via lateral to the base die couples to the metallization network to provide an electrical routing to the backside metallization of the integrated circuit die(s) through the via and the metallization network.

## Description

### BACKGROUND

Higher performance, lower cost, increased miniaturization, greater packaging density, and increased product flexibility of integrated circuit devices are ongoing goals of the electronics industry. Notably, heterogeneous integrated semiconductor devices are scaling both in power and compute bandwidth demands. Power levels in data center central processing unit (CPU) and graphics processing unit (GPU) are no track to exceed 1000W and the need to increase compute performance will require increase bandwidth and input/output (IO) routing challenges.

Current package architectures may not meet the future needs of CPU and GPU power and IO demands. It is with respect to these and other considerations that the present improvements have been needed. Such improvements may become critical as the desire to improve computing device performance and the corresponding necessity to remove heat from such devices becomes even more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 illustrates a cross-sectional side view of a multichip composite device including a topside metallization network to provide a power route to a backside of integrated circuit dies;
FIG. 2 illustrates a cross-sectional side view of an electrical routing in a multichip composite device;
FIG. 3 illustrates an enlarged cross-sectional side view of a region of the multichip composite device of FIG. 1;
FIG. 4 illustrates another enlarged cross-sectional side view of a multichip composite device having an inverted base die;
FIG. 5 illustrates a cross-sectional side view of an IC die showing further details of a device layer, a frontside metallization, and a backside metallization;
FIG. 6 illustrates a cross-sectional side view of a metallization die showing further details of a metallization network;
FIG. 7 illustrates a cross-sectional side view of an electrical routing in a multichip composite device;
FIG. 8 illustrates a cross-sectional side view of an electrical routing in a multichip composite device with multiple integrated circuit dies;
FIG. 9 illustrates a cross-sectional side view of an electrical routing in a multichip composite device with multiple base dies;
FIG. 10 illustrates a cross-sectional side view of a multichip composite device including a topside metallization network fabricated from one or more directly applied metallization levels to provide a power route to a backside of an integrated circuit die;
FIG. 11 illustrates a cross-sectional side view of a multichip composite device including a second integrated circuit die level on a topside metallization network;
FIG. 12 illustrates a cross-sectional side view of a multichip composite device having a component within a thickness of a topside metallization network;
FIG. 13 illustrates a cross-sectional side view of a multichip composite device having a bond wire topside metallization network;
FIG. 14 is a flow diagram illustrating methods for forming a multichip composite device including a topside metallization network to provide a power route to a backside of an integrated circuit die;
FIGS. 15, 16, 17, 18, 19, 20, 21, 22, 23, 25, 25, 26, 27, 28, 29, and 30 are cross-sectional side views of integrated circuit (IC) device structures evolving as the methods of FIG. 14 are practiced;
FIG. 31 illustrates an example microelectronic device assembly including a multichip composite device having a topside metallization network to provide a power route to a backside of an integrated circuit die;
FIG. 32 illustrates exemplary systems employing an IC assembly including a multichip composite device having a topside metallization network to provide a power route to a backside of an integrated circuit die; and
FIG. 33 is a functional block diagram of an electronic computing device, all in accordance with some embodiments.

### DETAILED DESCRIPTION

One or more embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/-10% of a target value.

The term layer and similar terms such as metallization or dielectric as used herein may include a single material or multiple materials or a single component or multiple components. The term metallization generally refers to metal layers (inclusive of metal lines or traces, and vias) that provide routing for electrical power, ground, IO, etc. delivery. The metal layers are generally patterned to form metal structures such as traces and vias. The metallization structures are separated by dielectric material or, simply, dielectric, which generally refers to any number of non-electrically conductive materials As used in throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. The terms "vertical", "vertically aligned" and similar terms indicate two or more components are aligned along the vertical direction, typically in a build-up direction of the device structure. As used herein, the term predominantly indicates the predominant constituent (i.e., greater than 50% is the constituent of greatest proportion in the layer or material). The term substantially pure indicates the constituent is not less than 99% of the material. The term pure indicates the constituent is not less than 99.5% of the material and the term completely pure indicates the constituent is not less than 99.9% of the material. As used herein, the terms "monolithic", "monolithically integrated", and similar terms indicate the components of the monolithic overall structure form an indivisible whole not reasonably capable of being separated.

As discussed, heterogeneous integrated semiconductor devices are scaling both in power and compute bandwidth demands. Advanced package architectures will continue to evolve to meet those demands. Notably, in integrated circuit (IC) devices, frontside and backside metallization has been introduced. In such IC dies, the device layer (e.g., a layer including transistors) is between a set of frontside metallization layers and a set of backside metallization layers. By including backside metallization layers in addition to traditional frontside metallization layers, a variety of advantages are attained. For example, power may be supplied from the backside, which frees up the frontside metallization layers for additional IO routing. By routing around the base die, vias can be removed from the base die to reduce the base die size or provide addition compute on the base die. Furthermore, the backside metallization may be thicker and have more a direct route to the device layer, which provides less power loss and other advantages. For example, introduction of frontside and backside metallization improves end-to-end power efficiency, removes routing constraints to allow increased IO routing and compute area per mm², and offers other advantages.

In current 3D package architectures, an interposer or base die(s) may be mounted to a package substrate and compute dies may be mounted over the interposer or base die(s). In such architectures, both power and IO are provided to the second level dies (e.g., compute dies) through the interposer or base die(s). This drives base die area and IO routing constraints, which limits total power delivery and end-to-end power efficiency. By disaggregating the package voltage regulator and improving interconnect systems, power delivery can be improved but IO and power routing constraints, and other difficulties persist.

In some embodiments, power routing from the package substrate through the base die to the second level dies (e.g., compute dies) is removed. The structures and architectures discussed herein, route power (and optionally IO) to a thick metal redistribution layer on top of the second level dies (e.g., compute dies). The power may be routed through a disaggregated voltage regulator (VR) to the thick metal redistribution layer, the power may be directly connected to the thick metal redistribution layer, or the power may be delivered through an alternative power delivery network component to the thick metal redistribution layer, which is on top of the second level dies (e.g., compute dies). Other routings to the thick metal redistribution layer may be used. This architecture leverages the previously discussed IC dies that include frontside metallization layers and backside metallization layers, such that the frontside metallization layers are adjacent to the interposer or base die(s) and the backside metallization layers (opposite a device layer from the frontside metallization layers) are on the topside of the second level dies (e.g., compute dies). Such structures and architectures provide a high efficiency interface for the second level dies (e.g., compute dies) and the system as a whole. For example, the topside power architecture and routing discussed herein reduces the IR drop due to reduced routing length, removes via and routing restrictions through the base die(s), reduces base die area requirements (e.g., due to the voltage regulator and vias for power delivery being removed) thereby shrinking die size for reduced costs, and allows for addition additional intellectual properties (IPs) to move to the base die(s) thereby freeing up compute area for increased cores/compute blocks and efficiency. Other advantages will be evident based on the following disclosure.

In some embodiments, a microelectronic device includes a multichip composite architecture that includes a base die, and one or more integrated circuit (IC) dies attached to the base die. As used herein, the term microelectronic device indicates a device including one or more integrated circuits to provide one or more functions. The microelectronic device may be at any level such as a packaged device, an assembly, an assembled motherboard, or a consumer product. The term multichip composite device indicates a device having a number of chips or dies that are integrated and formed into a quasi-monolithic structure. For example, a quasi-monolithic structure may have quasi-monolithic hierarchical integration of IC dies that couples base dies, IC dies or chiplets, and the like to form a composite structure of a processing system. Notably, the term composite indicates the structure has multiple components such as active dies, and dielectric material on and between the active dies. As used herein the terms base die, IC dies, and chiplets indicate dies or chips that are passive or having active circuitry (i.e., circuitry that is to provide electronic or device functionality when in operation). For example, the base die, IC dies, and chiplets may include processor circuitry, memory circuitry, control circuitry, signal and power routing circuitry, and so on. The term IC die may be used as an umbrella term with the term base die indicating an IC die deployed as a bottom or base layer die of the multichip composite device. The term chiplet can be deployed to indicate a top or mid-level IC die of the multichip composite device, although such dies may be referred to simply as IC dies.

Notably, the base die may or may not include functional circuitry (and may only include integrating metallization routing) while the higher-level IC die or dies typically include functional circuitry. Such IC dies may include a device layer between frontside and backside metallization of the IC dies. In some embodiments, the multichip composite device or architecture includes an IC die over and coupled to a base die. The IC die has a device layer between first and second stacks of metallization layers such that the first is proximal to the base die. The first stack of metallization layers is to provide signal routing to the device layer, as received through the base die. The second stack of metallization layers is to provide power routing (e.g., power and ground routing) to the device layer, the second stack typically has thicker and fewer metal lines for these purposes, as discussed further herein below.

The multichip composite device or architecture further includes a metallization network over the IC die and coupled to the second stack of metallization layers. The metallization network includes one or more thick metallization layers (e.g., each having a thickness of not less than five or ten or more times a thickness of any of the first or second stack of metallization layers). A via is adjacent the base die and coupled to the metallization network as well as an external interconnect such that a power route is provided to the second stack of metallization layers at the topside of the IC die. The power route may include the external interconnect the via, and a portion of the metallization network. The metallization network may be formed using any techniques discussed herein below.

Furthermore, the multichip composite device may include one or more dielectric materials laterally adjacent to the one or more IC dies or chiplets, over a region of the base die, and or laterally adjacent the base die. For example, the dielectric material may be formed over or around the dies to embed some or all of the dies in the dielectric material. In some embodiments, the dielectric materials include one or more inorganic dielectric materials. As used herein, the term inorganic dielectric material indicates materials not having carbon to hydrogen bonds and being characterized as an electrical insulator. For example, an inorganic dielectric material may have a resistivity comparable to that of silicon dioxide. Although carbon may not be a foundational component of the inorganic dielectric material, the inorganic dielectric material may include carbon as, for example, a dopant. In some embodiments, the dielectric materials include one or more organic dielectric materials. As used herein, the term organic dielectric material indicates materials having carbon to hydrogen bonds and carbon chains, and with the material being characterized as an electrical insulator

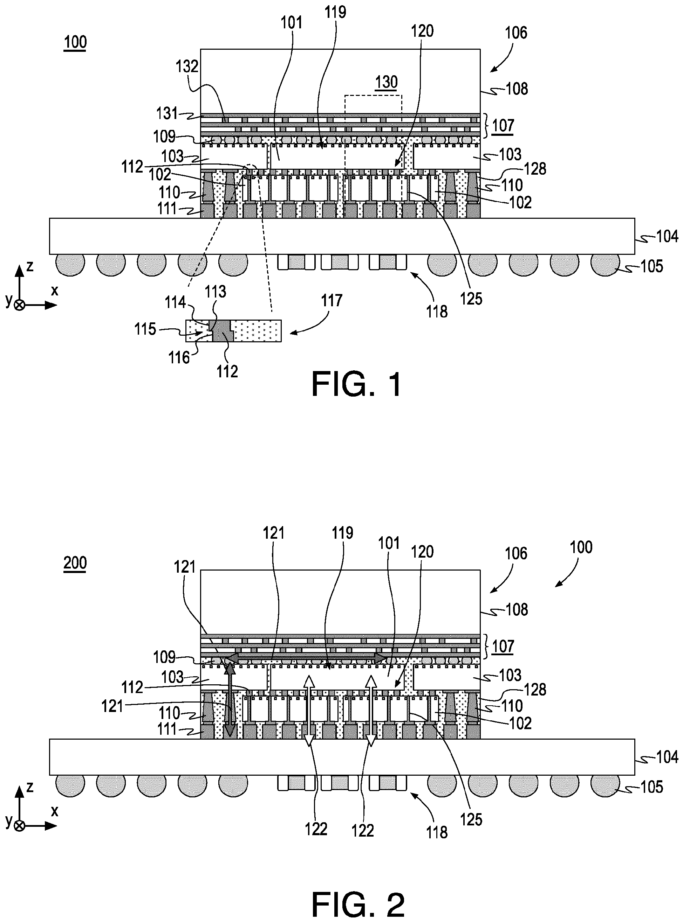

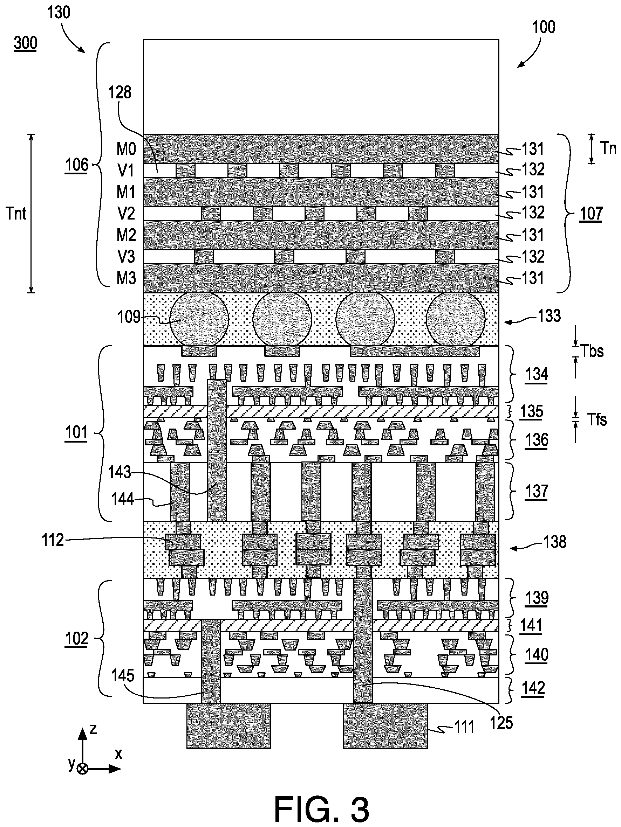

FIG. 1 illustrates a cross-sectional side view of a multichip composite device 100 including a topside metallization network 107 to provide a power route to a backside 119 of integrated circuit dies 101, arranged in accordance with some embodiments. Region 130 of multichip composite device 100 is illustrated in greater detail in FIG. 3 herein below. For example, multichip composite device 100 may be deployed in any microelectronic device. Multichip composite device 100 may include any number of IC dies 101 (which may be characterized as chiplets) coupled to topside surfaces of any number of base dies 102. Furthermore, multichip composite device 100 may include any number of chiplets or components lateral to IC dies 101 and/or base dies 102, such as voltage regulator (VR) dies 103. Although illustrated with respect to VR dies 103, which may be silicon substrate based voltage regulators and/or power delivery networks, multichip composite device 100 may omit VR dies 103 and use direct pass through power delivery. In the example, of FIG. 2, two-levels of dies are illustrated, but multichip composite device 100 may include any number of levels of dies such as three or more levels of dies.

Base dies 102 includes through vias 125 (e.g., through silicon vias, TSVs). As discussed, the terms IC die and chiplet indicate an active circuitry device (i.e., circuitry that is to provide computational functionality when in operation). For example, an IC die or chiplet may contain circuitry to perform a defined subset of functionality such as a memory chip, microprocessor, microcontroller, commodity IC (e.g., chip used for repetitive processing routines, simple tasks, application specific IC, etc.). The term base die also indicates an active circuitry device and may also be characterized as an IC die. For example, IC dies such as chiplets and base dies may be individual dies connected to create the functionalities of a monolithic IC. As shown, base dies 102 are at a lowest or base layer of multichip composite device 100. Furthermore, base dies 102 may interconnect, via interconnects 111, to a microelectronics substrate 104. For example, interconnects 111 may be package level interconnects to couple to a microelectronics substrate 104 such as a package substrate, board, or motherboard. Interconnects 111 may be interconnect posts or pads, solder bumps or balls, interconnects formed from a conductive film or conductive paste, or the like.

IC die 101 may be bonded to base die or dies 102 using any suitable technique or techniques such as hybrid bonding to form die level interconnects 112. In some embodiments, surfaces including metallization are interspersed among dielectric material may be formed on each of IC die 101 and base die or dies 102. In some embodiments, the patterning of the surfaces matches metal to metal and dielectric to dielectric for hybrid bonding. Such surface may then be brought together optionally under pressure and/or heat to meld the metal to form die level interconnects 112 and, optionally, to meld the dielectric material to form the hybrid bond. As shown with respect to the enlarged view, in some embodiments, die level interconnects 112 may include a misalignment 117 indicative of the hybrid bond. Misalignment 117 may include, for example, a first sidewall 114 misaligned with a second sidewall 116 such that a lateral offset 115 (i.e., measured in the x-dimension) is therebetween. In some embodiments, lateral offset 113 is in the range of 10 to 200 nm. Although any thicknesses may be used, in some embodiments, base die or dies 102 and IC die(s) 101 may have a thickness between 20 and 150 microns and IC die 101 may have a thicknesses between 20 and 50 microns. Although illustrated with respect to die level interconnects 112 being hybrid bonded interconnects, any interconnects such as solder balls or solder features may be deployed.

As shown in greater detail below, IC die 101 has backside 119 and frontside 120. Such terms are used in accordance with accepted practice in the art and indicate a build-up direction of the fabrication of IC die 101. Notably, the terms frontside and backside may be oriented with either side facing up in the assembly of multichip composite device 100 or other structures. For example, a device layer may be formed over a substrate on the frontside, with frontside metallization on or over the device layer. The backside is then opposite the device layer from the frontside. The device layer of IC die(s) 101 and/or base die(s) 102 may include any suitable devices such as transistors, capacitors, resistors, etc. Backside metallization may be formed opposite the frontside metallization with respect to the device layer using any suitable technique or techniques such as attachment to a carrier wafer, backside grind to expose the device layer (and buried through vias), and metallization fabrication processing (dual damascene processes or the like), as known in the art. In the context of multichip composite device 100, metallization die 106 includes a substrate 108 and metallization network 107.

Metallization network 107 may be built upon substrate 108 and metallization network 107 may include any number of relatively thick metallization levels 131 including metal lines or routes such that metallization levels 131 are interconnected by via levels 132 (e.g., a via layer). Metallization levels 131 are thick relative to the metal layers of the frontside metallization and the backside metallization of IC die 101. For example, each of metallization levels 131 may have a thickness of not less than five times the thickness of any metal layer of the frontside metallization and the backside metallization of IC die 101. In some embodiments, metallization network 107 may be characterized as a redistribution layer and metallization die 106 may be characterized as a redistribution die or substrate. Although illustrated with three metallization levels 131, metallization network 107 may include any number of such as a single metal layer 131, two metallization levels 131, four metallization levels 131, or more. In some embodiments, metallization network 107 includes a number of metallization levels 131 formed on substrate 108 and coupled, by interconnects 109 to IC dies 101 and/or VR dies 103. Although illustrated with respect to interconnects 109 being solder balls or solder features, any interconnects such as hybrid bonded interconnects may be used. In some embodiments, metallization network 107 includes a number of wire bonds or bond wires formed between IC dies 101 and/or VR dies 103. In some embodiments, metallization network 107 includes a number of a thick metal layers fabricated directly on or over IC dies 101 and/or VR dies 103.

As shown, metallization network 107 is coupled to microelectronics substrate 104 by one or more vias 110, which may be embedded in inorganic dielectric material 128. Inorganic dielectric material 128 may be any suitable material such as silicon oxide, silicon nitride, silicon oxynitride, carbon doped silicon oxide, or the like. For example, vias 110 may be characterized as through dielectric vias (TDVs) or pillars such as copper pillars. Via(s) 110 are laterally adjacent base dies 102 and couple with interconnects 111 for electrical attachment to microelectronics substrate 104. As used herein, the term laterally adjacent indicates at least a portion of the components are aligned in the x-y plane (i.e., orthogonal to the discussed vertical build-up direction). Via(s) 110 may be made of any appropriate conductive material or materials, such as copper, silver, nickel, gold, and aluminum, alloys thereof, and the like. In the context of multichip composite device 100, pertinent ones of interconnects 111, via(s) 110, VR die(s) 103 (if deployed), and metallization network 107 provide a power routing (and optional IO routing) to backside 119 of IC die(s) 101 while pertinent ones of interconnects 111 provide and base die(s) 102 provide an IO routing to frontside 120. As used herein, power indicates a power supply to operate devices (and is inclusive of power and ground) while IO indicates the signals under which the devices are operated.

IC die(s) 101, base die(s) 102, and metallization die(s) 106 may include any suitable substrates and pertinent device components. In some embodiments, IC die(s) 101 and/or base die(s) 102 are semiconductor dies having a device layer and metallization layers fabricated using known semiconductor manufacturing processes. In some embodiments, the substrate of any of IC die(s) 101, base die(s) 102, and metallization die(s) 106 is a substantially monocrystalline semiconductor, such as silicon or germanium, however other material systems may be deployed. In some embodiments, substrate 108 of metallization die(s) 106 is a silicon substrate, and substrate 108 acts as a heat spreader to remove heat from IC die(s) 101. For example, substrate 108 and/or metallization network 107 may act as a heat spreader to remove heat from IC die(s) 101. In some embodiments, substrate 108 is or includes a material to promote heat removal. In some embodiments, substrate 108 is or includes silicon, aluminum nitride, aluminum, copper, or other heat conductive material. In such contexts, substrate 108 may be characterized as a passive integrated heat spreader. In some embodiments, metallization network 107 may be fabricated on an active heat removal device such as a heat pipe, a thermoelectric cooler, or the like. In such contexts, the underling device (on which metallization network 107 is fabricated) may be characterized as active integrated heat spreader.

In some embodiments, substrate 108 is a glass substrate. The glass substrate may have any suitable characteristics. In some embodiments, the glass substrate is or includes a layer of glass (e.g., a glass core). In some embodiments, the glass substrate is an amorphous solid glass layer. In some embodiments, the glass substrate is or includes a layer of glass, which, for example, is one of aluminosilicate, borosilicate, alumino-borosilicate, silica, and fused silica. The layer of glass may include one or more of additives including Al₂O₃, B₂O₃, MgO, CaO, SrO, BaO, SnO₂, Na₂O, K₂O, P₂O₃, ZrO₂, Li₂O, Ti, or Zn. For example, the layer of glass may include an additive including one or more of aluminum, boron, magnesium, calcium, strontium, barium, tin, sodium, potassium, phosphorous, zirconium, lithium, titanium, or zinc. In some embodiments, the layer of glass may include silicon and oxygen and one or more of aluminum, boron, magnesium, calcium, strontium, barium, tin, sodium, potassium, phosphorous, zirconium, lithium, titanium, and zinc. In some embodiments, the layer of glass includes at least 23 percent silicon and at least 26 percent oxygen by weight, and further includes at least 5 percent aluminum by weight. In some embodiments, the layer of glass is rectangular in shape in plan view. However, other shapes may be used. In some embodiments, the glass substrate is absent any organic adhesive or other organic material.

As shown, base die(s) 102 are coupled to microelectronics substrate 104 by interconnects 111. Microelectronics substrate 104 may be any appropriate structure or carrier. In some embodiments, microelectronics substrate 104 includes dielectric material layers, which may include build-up films and/or solder resist layers, and may be composed of any appropriate dielectric material, including, but not limited to, bismaleimide triazine resin, fire retardant grade 4 material, polyimide material, silica filled epoxy material, glass reinforced epoxy material, low temperature co-fired ceramic materials, and the like, as well as low-k and ultra-low-k dielectrics (dielectric constants less than about 3.6), including, but not limited to, carbon doped dielectrics, fluorine doped dielectrics, porous dielectrics, organic polymeric dielectrics, fluoropolymers, and the like. Microelectronics substrate 104 may further include conductive routes or metallization extending through microelectronics substrate 104 such that, as with other metallization layers discussed herein, the conductive routes may be a combination of conductive traces and conductive vias extending through the dielectric material layers. The conductive traces and the conductive vias may be made of any appropriate conductive material or materials, including but not limited to, metals, such as copper, silver, nickel, gold, and aluminum, alloys thereof, and the like. Microelectronics substrate 104 may be a cored substrate or a coreless substrate. In some embodiments, components such as passive components 118 may be deployed on a backside of microelectronics substrate 104.

As shown, microelectronics substrate 104 includes external interconnects 105 for coupling to an external device, not shown. In some embodiments, external interconnects 105 may be disposed on bond pads on an opposite surface of microelectronics substrate 104 relative to that of interconnects 111. External interconnects 105 may be any appropriate electrically conductive material, including, but not limited to, metal filled epoxies and solders, such as tin, lead/tin alloys (for example, 63% tin / 37% lead solder), and high tin content alloys (e.g. 90% or more tin, such as tin/bismuth, eutectic tin/silver, ternary tin/silver/copper, eutectic tin/copper, and similar alloys). External interconnects 105 may be used to attach microelectronics substrate 104 to an external substrate (not shown), such as a motherboard.

FIG. 2 illustrates a cross-sectional side view of electrical routing 200 in multichip composite device 100, arranged in accordance with some embodiments. As shown, in some embodiments, a power routing 121 is provided to the topside of one or more IC dies 101, which includes backside 119 and the corresponding backside metallization of IC dies 101. In FIG. 2, power routing 121 is illustrated using two bi-directional arrows that have a darker shading relative to that of an IO routing 122. As discussed, power or power routing indicates the routing of power to operate devices (and is inclusive of power and ground), such that power routing 121 includes any conductive vias, paths, metallization, as well as any intervening devices between the power source and the device layer of one or more IC dies 101. In the context of FIG. 2, power routing 121 includes one or more interconnects 111, vias 110, VR dies 103, and metallization network 107, and die level interconnects 112. However, in some embodiments, power routing 121 does not include VR dies 103. For example, voltage regulation may be provided by a component embedded within metallization network 107 (and mounted to substrate 108), by a component mounted on microelectronics substrate 104, or a component otherwise deployed in multichip composite device 100.

Furthermore, FIG. 2 illustrates signal or IO routing 122, which includes the conductive vias, paths, metallization, any intervening devices, and so on to provide signal routing to one or more IC dies 101. As shown, IO routing 122 is provided to the bottom side of one or more IC dies 101, which includes frontside 120 and the corresponding frontside metallization of IC dies 101. IO routing 122 is again illustrated using two bi-directional arrows, and IO routing 122 provides the signals under which the devices are operated. IO routing 122 includes any conductive vias, paths, metallization, as well as any intervening devices between the external signal path and the device layer of one or more IC dies 101. In the context of FIG. 2, IO routing 122 includes one or more interconnects 111, base dies 102 (using through vias 125), and die level interconnects 112.

By removing power routing 121 from the same pathway and physical space as used by IO routing 122, the discussed advantages of freeing frontside metallization layers of IC dies 101 and through vias 125 for additional IO routing, having thicker power delivery pathways by deploying topside metallization network 107, having a more direct route to the device layer, and others are attained.

FIG. 3 illustrates an enlarged cross-sectional side view 300 of region 130 of multichip composite device 100, arranged in accordance with some embodiments. As shown in FIG. 3, multichip composite device 100 includes metallization network 107 over and coupled to IC die 101 by interconnects 109. For example, interconnects 109 may be part of an interconnect layer 133. IC die 101 is over and coupled to base die 102 by die level interconnects 112. For example, die level interconnects 112 may be part of a die level interconnect layer 138. As shown, IC die 101 includes a device layer 135 between frontside metallization 136 and backside metallization 134.

As discussed, frontside metallization 136 is formed over the frontside of device layer 135 and, subsequently, backside metallization 134 may be formed (by carrier wafer attachment, backside grind, and metallization) opposite device layer 135 from frontside metallization 136. Furthermore, metallization network 107 provides power delivery through backside metallization 134 while base die 102 provides IO routing through frontside metallization 136. In some embodiments, backside metallization 134 includes thicker metallization (e.g., metal lines or layers having a greater thickness in the z-dimension) than that of frontside metallization 136. Furthermore, metallization 136 may have fewer metallization layers (e.g., layers of metal lines) than that of frontside metallization 136. For example, thicker metallization may provide for more efficient power delivery while more metallization layers are needed for the complexity of IO signaling.

Metallization network 107 may include any number of metallization levels 131 and intervening via levels 132. The term metallization level indicates a network of substantially coplanar metal lines or conductive routes. A via level includes a network of substantially coplanar metal vias or conductive plugs that interconnect the metallization level. In the illustrated example, metallization network 107 has four metallization levels (M0, M1, M2, M3) and three intervening via levels (V1, V2, V3). However, any number of metallization levels and via levels may be used. In some embodiments, a single metallization level is deployed. Similarly, backside metallization 134 and frontside metallization 136 each include a number of metallization levels and intervening via levels. The individual ones of the metallization levels and intervening via levels of backside metallization 134 and frontside metallization 136 are illustrated further herein below.

In some embodiments, each metallization level of backside metallization 134 has a thickness Tbs, which may be the same across each metallization level of backside metallization 134, or the thickness Tbs of each level may increase moving away from device layer (i.e., in the positive z-direction). Similarly, each metallization level of frontside metallization 136 has a thickness Tfs, which again may be the same across each metallization level of frontside metallization 136, or the thickness Tfs of each level may increase moving away from device layer (i.e., in the negative z-direction). Also as shown, each metallization level of metallization network 107 has a thickness Tn. As with the other metallization layers, each metallization level of metallization network 107 may have the same thickness or the thickness Tn of each level may increase moving away from IC die 101 (i.e., in the positive z-direction).

In some embodiments, each metallization level of backside metallization 134 is thicker than every metallization level of frontside metallization 136. That is, the thickest metallization level of frontside metallization 136 may have thickness Tfs that is less than the thickness Tbs of the thinnest metallization level of backside metallization 134. In some embodiments, each metallization level of backside metallization 134 is at least as thick as every metallization level of frontside metallization 136. For example, the thickest metallization level of frontside metallization 136 may have thickness Tfs that is less than or equal to the thickness Tbs of the thinnest metallization level of backside metallization 134.

Furthermore, backside metallization 134 may have fewer metallization levels than the number of metallization levels of frontside metallization 136. In some embodiments, the number of metallization levels of backside metallization 134 is less than the number of metallization levels of frontside metallization 136. In some embodiments, a difference between the number of metallization levels of frontside metallization 136 and the number of metallization levels of backside metallization 134 is not less than three. In some embodiments, a difference between the number of metallization levels of frontside metallization 136 and the number of metallization levels of backside metallization 134 is not less than four or more.

Each metallization level 131 of metallization network 107 is much thicker than every metallization level of frontside metallization 136 and backside metallization 134. In some embodiments, the thickness Tn of the thinnest metallization level of metallization network 107 is a multiple of or order of magnitude greater than the thickness Tbs of the thickest metallization level of frontside metallization 136 and backside metallization 134. In some embodiments, the thickness Tn of the thinnest metallization level of metallization network 107 is not less than five times the thickness Tbs of the thickest metallization level of frontside metallization 136 and backside metallization 134. In some embodiments, the thickness Tn of the thinnest metallization level of metallization network 107 is not less than ten times the thickness Tbs of the thickest metallization level of frontside metallization 136 and backside metallization 134. In some embodiments, the thickness Tn of the thinnest metallization level of metallization network 107 is not less than 25 times the thickness Tbs of the thickest metallization level of frontside metallization 136 and backside metallization 134. In some embodiments, the thickness Tn of the thinnest metallization level of metallization network 107 is not less than 50 times the thickness Tbs of the thickest metallization level of frontside metallization 136 and backside metallization 134. In some embodiments, the thickness Tn of the thinnest metallization level of metallization network 107 is not less than 100 times the thickness Tbs of the thickest metallization level of frontside metallization 136 and backside metallization 134.

In some embodiments, metallization levels 131 of metallization network 107 are thicker than metallization levels of backside metallization 134, which are thicker than metallization levels of frontside metallization 136. In some embodiments, the thicknesses of each of the metallization levels of frontside metallization 136 Tfs are not more than 1 micron thick. In some embodiments, the thicknesses of each of the metallization levels of frontside metallization 136 Tfs are not more than 500 nm thick. In some embodiments, the thicknesses of each of the metallization levels of backside metallization 134 Tbs are on the order of 1 micron thick. In some embodiments, the thicknesses of each of the metallization levels of backside metallization 134 Tbs are not more than 1.5 micron thick. In some embodiments, the thicknesses of each of the metallization levels of backside metallization 134 Tbs are not more than 1.0 micron thick.

In contrast, metallization levels 131 of metallization network 107 are orders of magnitude larger. In some embodiments, the thicknesses of each of metallization levels 131 of metallization network 107 Tn are not less than 10 microns thick. In some embodiments, the thicknesses of each of metallization levels 131 of metallization network 107 Tn are not less than 25 microns thick. In some embodiments, the thicknesses of each of metallization levels 131 of metallization network 107 Tn are not less than 50 microns thick. In some embodiments, the thicknesses of each of metallization levels 131 of metallization network 107 Tn are in the range of 10 to 100 microns thick. Metallization network 107 further has an overall thickness Tnt (network thickness total). As discussed here below, a component may be embedded within the overall thickness Tnt of metallization network 107.

That is, the thickest metallization level of frontside metallization 136 may have thickness Tfs that is less than the thickness Tbs of the thinnest metallization level of backside metallization 134. In some embodiments, each metallization level of backside metallization 134 is at least as thick as every metallization level of frontside metallization 136. For example, the thickest metallization level of frontside metallization 136 may have thickness Tfs that is less than or equal to the thickness Tbs of the thinnest metallization level of backside metallization 134.

In some embodiments, IC die 101 further includes a substrate layer 137 including through vias 144. Vias 144 extend from die level interconnect layer 138 to frontside metallization 136, and vias 144 may be made of any appropriate conductive material such as copper. In some embodiments, IC die 101 includes backside vias 143 that extend from interconnect layer 138 to backside metallization 134. Backside vias 143 may also be any appropriate conductive material such as copper. Vias 144 and backside vias 143 may be formed using any suitable technique or techniques and may extend through substrate layer 137, which provides structural support during fabrication. In some embodiments, one or both of vias 144 and backside vias 143 are not deployed.

Also as shown, base die 102 may include a device layer 141 between frontside metallization 140 and backside metallization 139. In some embodiments, base die 102 does not includes such layers and instead only includes through vias 125. In some embodiments, base die 102 further includes vias 145 and frontside vias 145. Device layer 141, frontside metallization 140, backside metallization 139, vias 145, and frontside vias 145 may have any characteristics discussed above with respect to device layer 135, frontside metallization 136, backside metallization 134, vias 144, and backside vias 143. Notably, in the context of FIG. 3, frontside metallization 136 and backside metallization 139 are proximal one another.

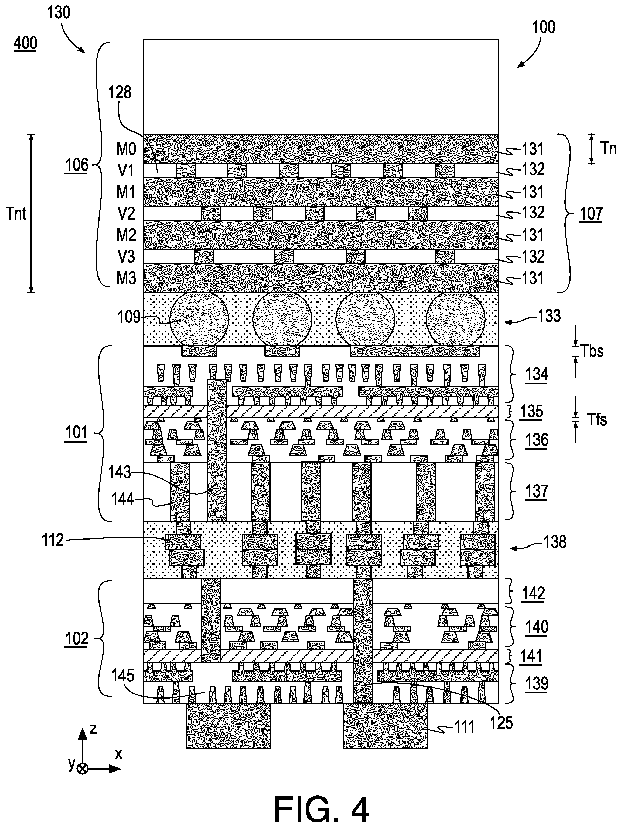

FIG. 4 illustrates enlarged cross-sectional side view 400 of region 130 of multichip composite device 100 having an inverted base die 102, arranged in accordance with some embodiments. As shown in FIG. 4, base die 102 may be inverted relative to the multichip composite device 100 of FIG. 3 such that frontside metallization 136 and frontside metallization 140 are proximal one another. In other aspects the components of multichip composite device 100 may have any characteristics discussed herein. It is also noted that base die 102 may not include device layer 141 such that it provides only redistribution and base die 102 may be characterized as an interposer. In other examples, base die 102 may only include frontside metallization 140 (e.g., base die 102 may be absent backside metallization 139). Other base die 102 architectures may be used.

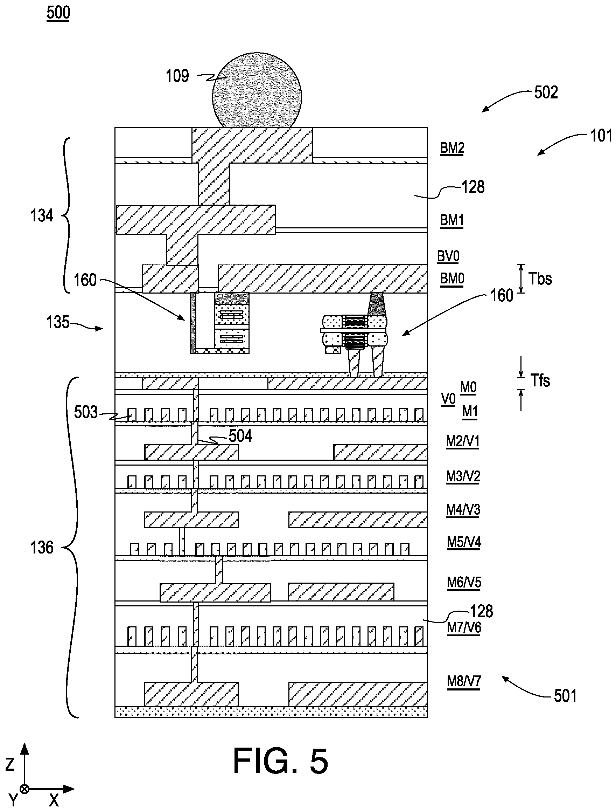

FIG. 5 illustrates a cross-sectional side view 500 of IC die 101 showing further details of device layer 135, frontside metallization 136, and backside metallization 134, arranged in accordance with some embodiments. Frontside metallization 136 and backside metallization 134 may be formed using any suitable technique or techniques such as dual damascene techniques, single damascene techniques, subtractive metallization patterning techniques, or the like. As discussed, interconnectivity, signal routing, IO routing, and the like may be provided by frontside metallization 136. Frontside metallization 136 includes any number of metallization and via levels 501 such that via levels are between and interconnect metallization levels. For example, metal routes or lines 503 of the metallization level are interconnected by vias, such as vias 504.

As shown, in some embodiments, frontside metallization 136 are formed over one side of device layer 135, which may include transistor structures 160. In the context of FIG. 5, transistor structures 160 are gate-all-around field effect transistors (GAA-FETs), however, transistor structures 160 may be any suitable devices such as planar FETs, FinFETs, or the like, or device layer 135 may include other functional device structures. In the illustrated example, frontside metallization 136 include M0, V0, M1, M2/V1, M3/V2, M4/V3, M5/V4, M6/V5, M7/V6, and M8/V7. However, M4/V3 may include any number of metallization levels and corresponding via levels such as six, eight, or more metallization layers.

Similarly, backside metallization 134, which includes any number of thicker metallization and via levels metallization and via levels 502 (as discussed above). For example, metallization and via levels metallization and via levels 502 may include backside metallization level 0 (BM0), backside via level 0 (BV0), backside metallization level 1 (BM1), backside via level 1 (BV1), backside metallization level 2 (BM2), and so on. As shown, interconnects 109 may contact a backside metallization level of backside metallization 134 for interconnection to metallization network 107. Backside metallization 134 is formed over and immediately adjacent device layer 135, and opposite device layer 135 from frontside metallization 136. In the illustrated example, the metallization levels of backside metallization 134 include BM0, BM1, and BM2 with intervening via layers. However, backside metallization 134 may include any number of metallization levels such as four, five, or more metallization layers.

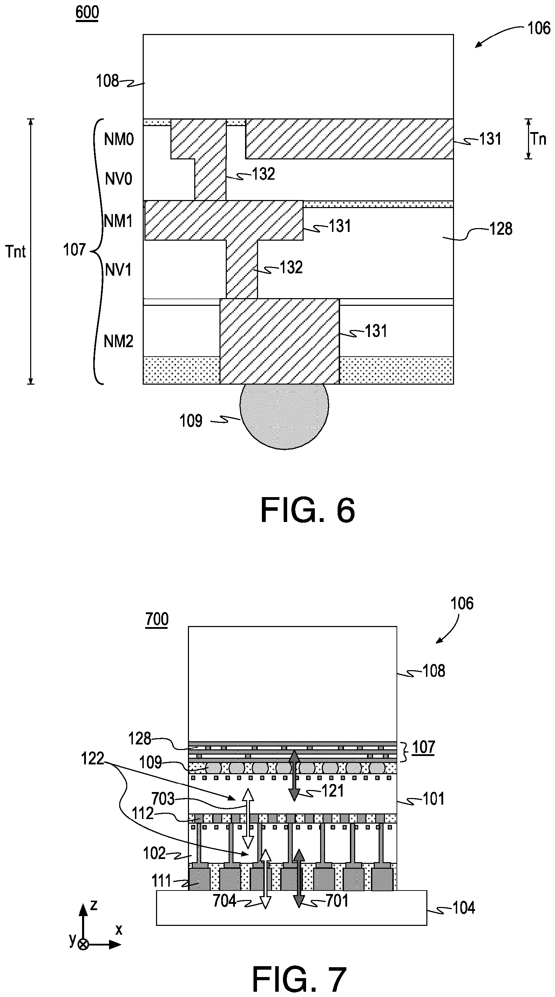

FIG. 6 illustrates a cross-sectional side view 600 of metallization die 106 showing further details of metallization network 107, arranged in accordance with some embodiments. Metallization network 107 may be formed using any suitable technique or techniques such as dual damascene techniques, single damascene techniques, subtractive metallization patterning techniques, or the like. In the illustrated example, metallization network 107 is fabricated on substrate 108 a part of metallization die 106. However, in other contexts, metallization network 107 may be formed directly over IC dies 101 or from wire bond techniques, as discussed further herein below. Metallization network 107 provides a topside power routing to IC die(s) 101 by connection through interconnects 109. In some embodiments, metallization network 107 may further provide optional IO routing as discussed further herein below.

Metallization network 107 may include any number of thicker metallization levels 131 and via levels 132. For example, metallization levels 131 and via levels 132 may include power network metallization level 0 (NM0), power network via level 0 (NV0), power network metallization level 1 (NM1), power network via level 1 (NV1), power network metallization level 2 (NM2), and so on. As shown, interconnects 109 may contact a backside or via metallization level of metallization network 107 for interconnection to IC die 101 using interconnects 109. In some embodiments, metallization network 107 is formed over or on substrate 108. In the illustrated example, metallization network 107 includes three metallization levels 131 and two intervening via levels 132. However, metallization network 107 may include any number of metallization layers such as one, two, four, five, or more metallization layers.

FIG. 7 illustrates a cross-sectional side view of an electrical routing 700 in multichip composite device 100, arranged in accordance with some embodiments. As discussed with respect to FIG. 2, in some embodiments, power routing 121 is provided to the topside of IC dies 101 to couple directly to backside metallization of IC dies 101, and signal or IO routing 122 is routed to frontside metallization of IC dies 101 through base dies 102.

As shown in FIG. 7, in some embodiments, signal or IO routing 122 includes a first routing 704 from microelectronics substrate 104, though interconnects 111, to base die 102, and a second routing 703 from base die 102 to IC die 101 through die level interconnects 112. For example base die 102 may passively route IO routing 122 from microelectronics substrate 104 to IC die 101 (using through vias 125, for example) or base die 102 may manipulate the signal as part of IO routing 122. Also as shown in FIG. 7, power may be provided to base die 102 through a power routing 701. In some embodiments, power routing 701 is from microelectronics substrate 104, though interconnects 111, to base die 102.

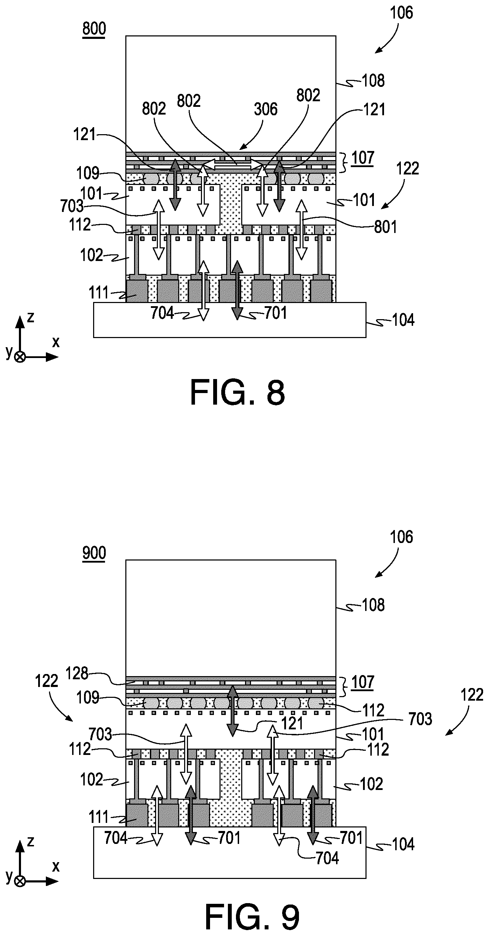

FIG. 8 illustrates a cross-sectional side view of an electrical routing 800 in multichip composite device 100 with multiple integrated circuit dies 101, arranged in accordance with some embodiments. As shown in FIG. 8, power routing 121 may be provided to the topside of any number IC dies 101 through metallization network 107. Furthermore, in some embodiments, signal or IO routing 122 may further include a third routing 801 from base die 102 to another IC die 101 through die level interconnects 112. Base die 102 may passively provide second routing 703 and third routing 801, or base die 102 may manipulate the signal as part of IO routing 122.

Also as shown in FIG. 8, metallization network 107 may be used to provide, in addition to power routing 121, a signal or IO routing 802 between IC dies 101. For example, signal or IO routing 802 may extend from a frontside metallization of a first one of IC dies 101, through particular ones of interconnects 109, through metallization network 107, through ones of interconnects 109, to a second one of IC dies 101. For example, metallization network 107 may provide additional routing and architectural flexibility, in addition to that provided by moving power routing 121 to metallization network 107. In some embodiments, signal or IO routing 802 may be characterized as an IO bridge, and signal or IO routing 802 may relieve the base day from some of the IO routing.

FIG. 9 illustrates a cross-sectional side view of an electrical routing 900 in multichip composite device 100 with multiple base dies 102, arranged in accordance with some embodiments. As shown in FIG. 9, power routing 121 is provided to the topside of IC dies 101 to couple directly to backside metallization of IC dies 101. In addition, electrical routing 900 includes multiple IO routings 122 that each include a first routing 704 from microelectronics substrate 104, though interconnects 111, to one of base dies 102, and a second routing 703 from each of base dies 102 to IC die 101 through die level interconnects 112. Base dies 102 may passively route IO routings 122 or base dies 102 may manipulate the signal as part of IO routings 122.

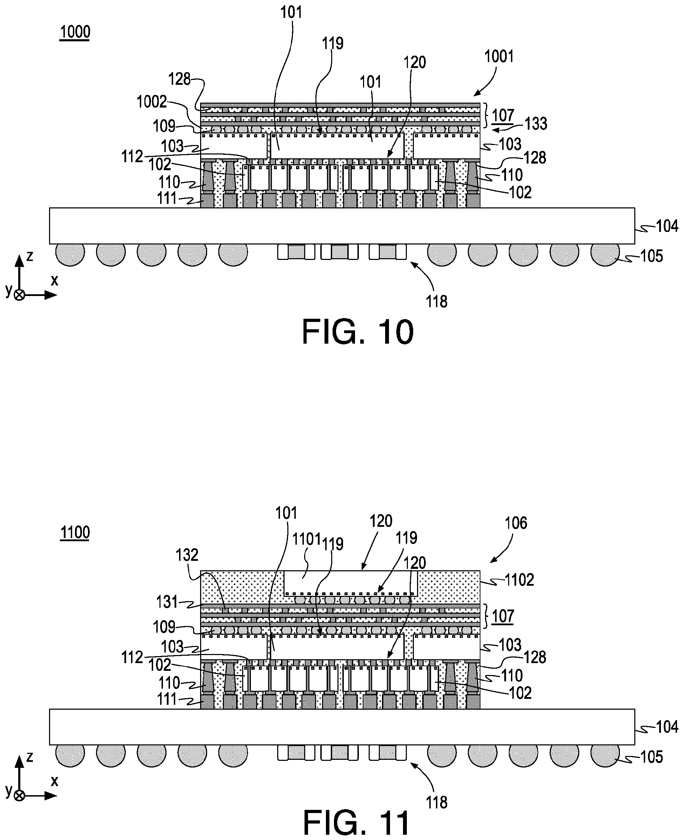

FIG. 10 illustrates a cross-sectional side view of a multichip composite device 1000 including topside metallization network 107 fabricated from one or more directly applied metallization levels 1001 to provide a power route to a backside 119 of integrated circuit die 101, arranged in accordance with some embodiments. As discussed, in some embodiments, topside metallization network 107 may be formed on substrate 108 as part of metallization die 106, and metallization die 106 may be coupled to backside 119 of IC die 101.

In other embodiments, metallization network 107 may be formed over IC dies, such as on a surface of interconnect layer 133. For example a top surface of interconnect layer 133 may include exposed portions of interconnects 109 substantially coplanar with a dielectric material 1002. Metallization network 107 is then formed on the surface using any suitable technique or techniques. In some embodiments, metallization network 107 is formed using additive processing techniques. In some embodiments, metallization network 107 is formed using screen printing techniques. Any number of metallization levels (i.e., one or more) and intervening via levels (if multiple metallization levels are deployed) may be fabricated, and metallization network 107 (absent substrate 108) may have any characteristics discussed elsewhere herein.

FIG. 11 illustrates a cross-sectional side view of a multichip composite device 1100 including a second integrated circuit die level on topside metallization network 107, arranged in accordance with some embodiments. For example, multichip composite device 1100 is similar to multichip composite device 1000 after attachment of IC die 1101 to metallization network 107, and formation of dielectric material 1102. In some embodiments, metallization network 107 is fabricated using additive techniques as discussed with respect to FIG. 10 such that a top surface of metallization network 107 is exposed for attachment of IC die 1101. In other embodiments, substrate 108 may be removed to expose metallization network 107 for attachment of IC die 1101. For example, substrate 108 may be removed using grinding techniques, etch techniques, or combinations thereof.

IC die 1101 may have any characteristics discussed herein with respect to IC die 101 such that IC die 1101 includes backside metallization at backside 119 and frontside metallization at frontside 120. The backside metallization at backside 119 is opposite a device layer from frontside metallization at frontside 120 (refer to FIG. 5). Notably, backsides 119 of both IC die 101 and IC die 1101 are proximal to metallization network 107 for power delivery directly to the backside metallization layers of IC die 101 and IC die 1101. Signal and IO routing may be provided to IC die 1101 through metallization network 107 and IC die 101 or through alternative routing laterally adjacent to metallization network 107, IC die 101, and base die 102.

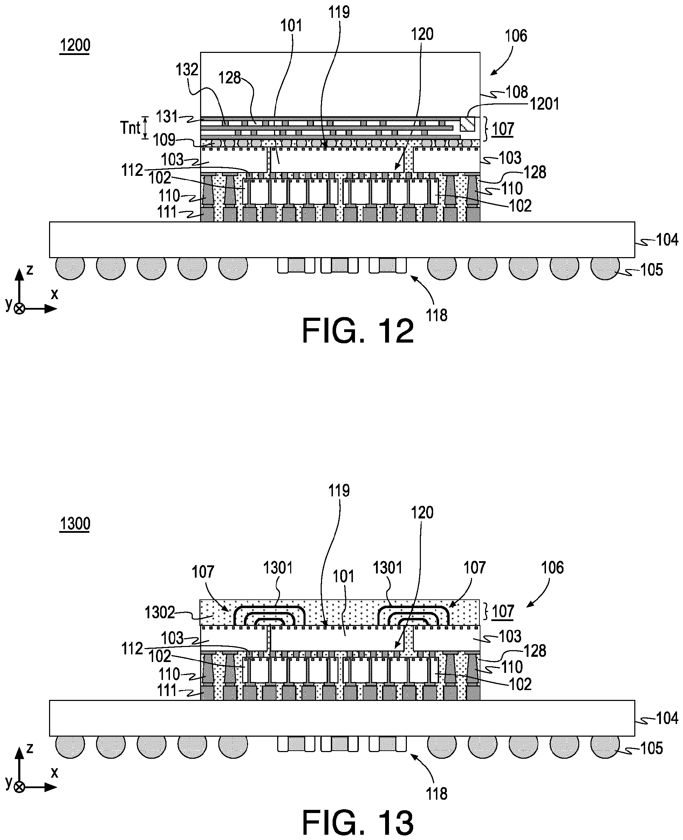

FIG. 12 illustrates a cross-sectional side view of a multichip composite device 1200 having a component 1201 within a thickness of topside metallization network 107, arranged in accordance with some embodiments. As shown with respect to FIGS. 3, 4, and 6, metallization network 107 has an overall thickness Tnt. In some embodiments, the overall thickness Tnt of metallization network 107 is in the range of about 25 to 500 microns. In some embodiments, such overall thicknesses of metallization network 107 allow for insertion of a component 1201 fully within the overall thicknesses of metallization network 107. For example, both opposing surfaces of component 1201 orthogonal to the z-direction may both be fully within the overall thickness Tnt of metallization network 107.

Component 1201 may be any suitable active or passive component such as an IC die, a voltage regulator, a capacitor, an inductor, or circuits including such devices. In some embodiments, component 1201 is attached to a surface of substrate 108, and metallization network 107 inclusive of metallization levels 131, via levels 132, and dielectric material 128 are built up adjacent to component 1201. In some embodiments, component 1201 is an inductor directly attached to a surface of substrate 108 such that metallization network 107 is on the same surface of substrate 108. In some embodiments, a component such as an inductor is deployed on microelectronics substrate 104.

FIG. 13 illustrates a cross-sectional side view of a multichip composite device 1300 having a bond wire 1301 topside metallization network 107, arranged in accordance with some embodiments. As discussed herein, metallization network 107 may include a number of metallization levels 131 with via levels 132 therebetween (refer to FIG. 4) such that metallization levels 131 include substantially planar metallization features such as conductive routes or metal lines. In some embodiments, metallization network 107 instead includes a number of bond wires 1301 embedded in a mold material 1302.

Bond wires 1301 may be formed using any suitable technique or techniques to couple bond pads between IC die 101 and VR dies 103. In some embodiments, bond wires 1301 form inductors between IC die 101 and VR dies 103. For example, mold material 1302 may be a magnetic material. Bond wires 1301 may have any thicknesses discussed herein with respect to metallization levels 131 to form an efficient metallization network 107. In some embodiments, the thickness of each of bond wires 1301 may be a diameter or width of bond wires 1301 orthogonal to a linear dimension of each of bond wires 1301.

In some embodiments, the width of each of bond wires 1301 of metallization network 107 is not less than five times the thickness Tbs of the thickest metallization level of frontside metallization 136 and backside metallization 134. In some embodiments, the width of each of bond wires 1301 of metallization network 107 is not less than ten times the thickness Tbs of the thickest metallization level of frontside metallization 136 and backside metallization 134. In some embodiments, the width of each of bond wires 1301 of metallization network 107 is not less than 25 times the thickness Tbs of the thickest metallization level of frontside metallization 136 and backside metallization 134. In some embodiments, the width of each of bond wires 1301 of metallization network 107 is not less than 50 times the thickness Tbs of the thickest metallization level of frontside metallization 136 and backside metallization 134. In some embodiments, the width of each of bond wires 1301 of metallization network 107 is not less than 100 times the thickness Tbs of the thickest metallization level of frontside metallization 136 and backside metallization 134.

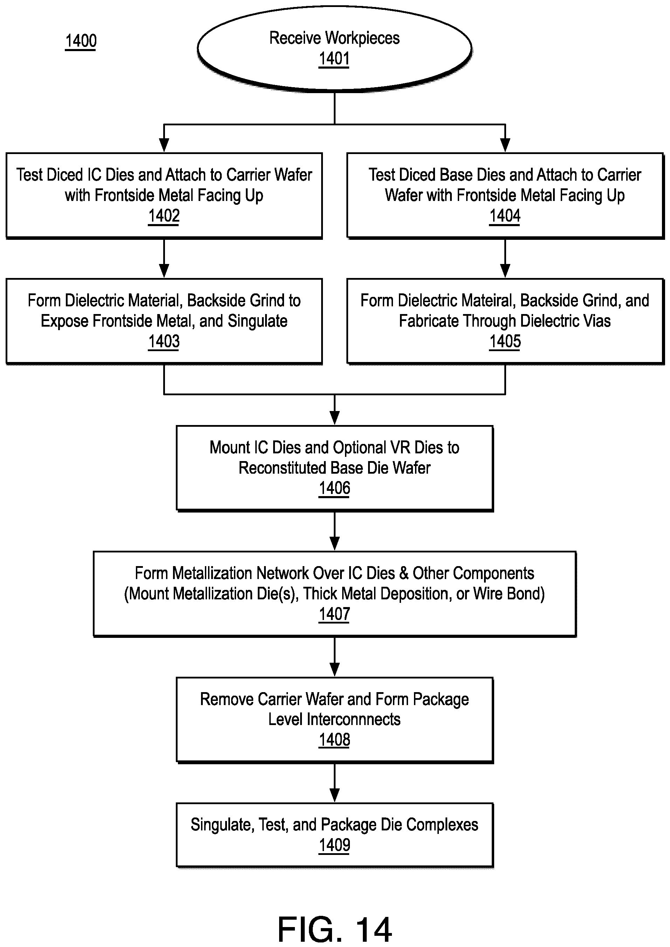

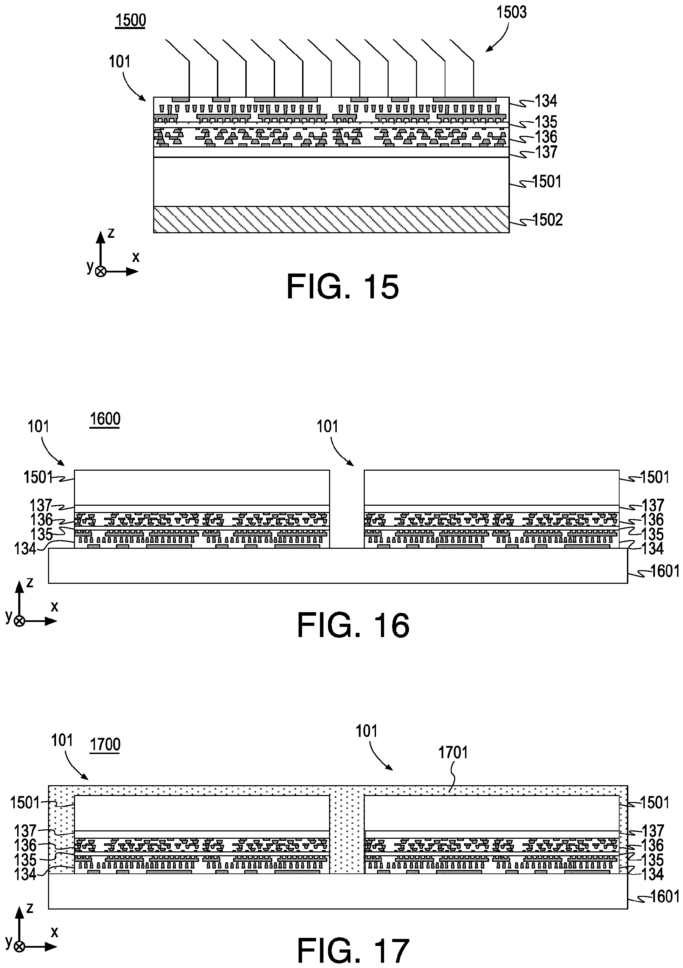

FIG. 14 is a flow diagram illustrating methods 1400 for forming a multichip composite device including a topside metallization network to provide a power route to a backside of an integrated circuit die, arranged in accordance with at least some implementations of the present disclosure. FIGS. 15, 16, 17, 18, 19, 20, 21, 22, 23, 25, 25, 26, 27, 28, 29, and 30 are cross-sectional side views of integrated circuit (IC) device structures evolving as methods 1400 are practiced, arranged in accordance with some embodiments of the disclosure.

Methods 1400 begin at input operation 1401, where workpieces are received for processing. For example, fully or partially fabricated IC dies, base dies, VR dies, metallization dies, and other components may be received for processing. The received dies may be part of a substrate structure or they may be diced from a substrate. In some embodiments, the discussed multichip composite devices may be fabricated on reconstituted wafers such that IC dies are coupled to base dies (as a reconstituted base die wafer), or base dies are coupled IC dies (as a reconstituted IC die wafer) using die to wafer bonding. In some embodiments, wafer to wafer bonding techniques are used. Furthermore, either before or after attachment, other components, such as through dielectric vias adjacent the base dies or metallization networks over IC dies, may be fabricated. For example, methods 1400 include exemplary fabrication methods that may be performed out of order, or using other techniques to fabricate the multichip composite devices discussed herein.

Processing continues at operations 1402 and 1404. At operation 1402, diced or singulated IC dies are tested and, those that pass test, are attached to a carrier wafer with frontside metallization facing up (i.e., away from the carrier wafer). The testing may be performed using any suitable technique or techniques such as coupling probe pins to conductive pads on the IC dies and probing (using test circuitry) various pathways of the IC dies. Those that pass test are attached to a carrier wafer using any suitable technique or techniques such as die to wafer bonding using adhesives, laminates, tapes, or the like. Similarly, at operation 1404, diced or singulated base dies are tested and attached to a carrier wafer again with frontside metallization facing up (i.e., away from the carrier wafer). The testing may be performed using any suitable technique or techniques such as those discussed with respect to operation 1402.

FIG. 15 illustrates a cross-sectional side view of integrated circuit die 101 under test 1500. IC die 101 includes or is attached to a substrate 1501. IC die 101 further includes frontside metallization 136, device layer 135, backside metallization 134, and optional substrate layer 137. As shown, IC die 101 may be attached or mounted to a thermal head 1502, which provides temperature control and optional temperature stressing during test. Probe pins 1503 are coupled to backside metallization 134 and are used to test various components of IC die 101 such as active or test components of device layer 135.

FIG. 16 illustrates a cross-sectional side view of a device structure 1600 including a number of IC dies 101 attached to a carrier wafer 1601 such that backside metallization 134 is proximal to carrier wafer 1601 and frontside metallization 136 is facing up and away from carrier wafer 1601 (i.e., frontside metallization 136 is distal from carrier wafer 1601). Carrier wafer 1601 may be any suitable material in any suitable format. For example, carrier wafer 1601 may be a monocrystalline silicon wafer. Although discussed with respect to a wafer format, any carrier format such as a panel may be used. IC dies 101 may be attached to carrier wafer 1601 using adhesives, laminates, tapes, or the like, as known in the art.

Returning to FIG. 14, processing continues from operation 1402 at operation 1403, where a dielectric or mold material is formed around the attached IC dies, and over the carrier substrate. A backside grind is then performed to remove the substrate from over the frontside metallization and to provide a planar surface relative to the dielectric or mold material. Alternatively, the substrate may be removed, the dielectric or mold material may be formed, and planarization operations may be performed. Subsequently, the IC dies and carrier wafer are singulated such that each IC die now has its frontside metallization exposed and prepared for coupling to a base die, as discussed further herein below.

FIG. 17 illustrates a cross-sectional side view of a device structure 1700 similar to device structure 1600 having a dielectric material 1701 formed over and around IC dies 101 such that IC dies 101 are embedded in dielectric material 1701. Dielectric material 1701 may be any suitable dielectric material such as an inorganic or organic dielectric material. In some embodiments, dielectric material 1701 is or includes one or more of silicon dioxide, silicon nitride, silicon carbon-nitride. In some embodiments, dielectric material 1701 is or includes a polymeric material. In some embodiments, dielectric material 1701 is a mold material. Dielectric material 1701 may be formed using any suitable deposition technique or techniques.

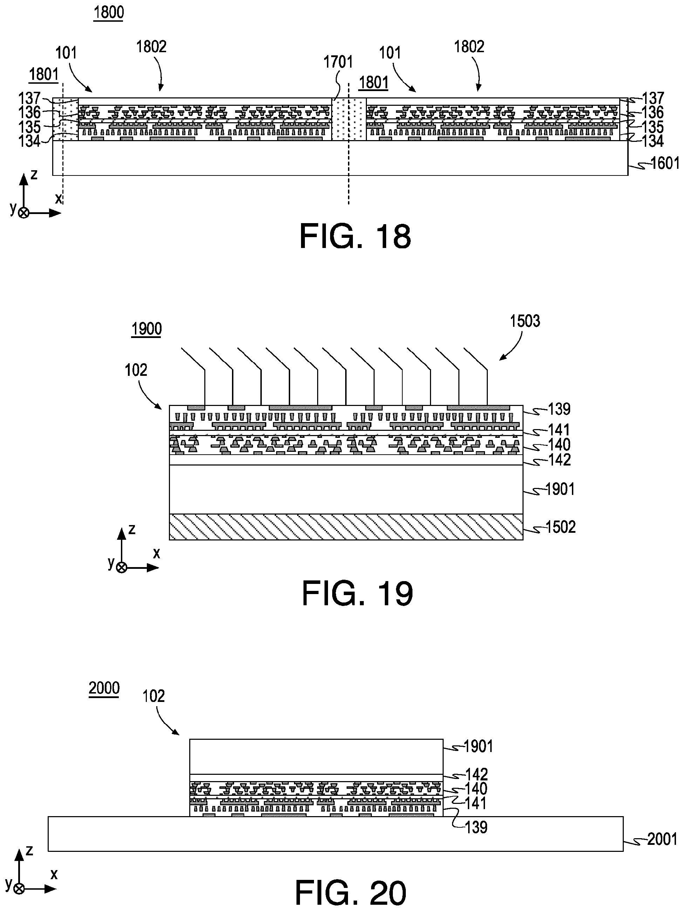

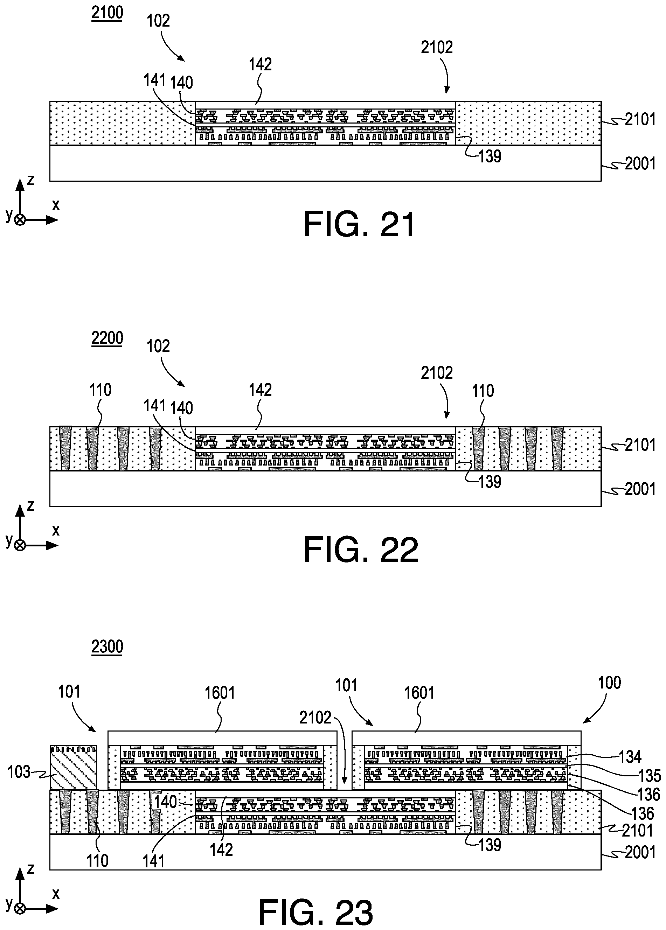

FIG. 18 illustrates a cross-sectional side view of a device structure 1800 similar to device structure 1700 after backside material operation(s) to remove substrate 1501 and portions of dielectric material 1701. Such backside material operation(s) may include any suitable techniques such as backside grind operations, chemical removal or etch operations, planarization operations, or the like. As discussed, in some embodiments, dielectric material 1701 is applied after removal of substrate 1501, which is followed by planarization. As shown, a substantially planar surface 1802 of each of IC dies 101 is exposed for die attachment. In the illustrated embodiment, optional substrate layer 137 remains and is exposed, however, in some embodiments, frontside metallization 136 is exposed. Furthermore, device structure 1800 illustrates example dice lines or scribe lines 1801 where IC dies 101 may be diced or segmented from carrier wafer 1601. Such diced IC dies 101 may then be attached to base dies as discussed herein below with respect to FIG. 23.

With reference to FIG. 14, as discussed, at operation 1404, diced or singulated base dies are tested and attached to a carrier wafer with frontside metallization facing up (i.e., away from the carrier wafer).

FIG. 19 illustrates a cross-sectional side view of base die 102 under test 1900. Base die 102 includes or is attached to a substrate 1901, and base die 102 may further include frontside metallization 140, device layer 141, backside metallization 139, and optional substrate layer 142. As discussed herein, in some embodiments, base die 102 does not include device layer 141 but instead includes IO routing. In such contexts device test is not needed but routing tests may still be performed. Base die 102 may be attached or mounted to thermal head 1502 and may be tested using probe pins 1503 that couple to backside metallization 139.

FIG. 20 illustrates a cross-sectional side view of a device structure 2000 including a base die 102 attached to a carrier wafer 2001. Although illustrated with respect to a single base die 102 attached to carrier wafer 2001, any number of base dies may be attached to carrier wafer 2001 for processing. As shown, backside metallization 139 is proximal to carrier wafer 2001 and frontside metallization 140 is facing up and away from carrier wafer 2001. Carrier wafer 2001 may be any suitable material in any suitable format such as those discussed with respect to carrier wafer 1601.Base die may be attached to carrier wafer 2001 using adhesives, laminates, tapes, or the like.

Returning to FIG. 14, processing continues from operation 1404 at operation 1405, where a dielectric or mold material is formed around the attached base dies, and over the carrier substrate. A backside grind is then performed to remove the substrate from over the frontside metallization and to provide a planar surface relative to the dielectric or mold material. Alternatively, the substrate may be removed, the dielectric or mold material may be formed, and planarization operations may be performed. Subsequently, through dielectric vias are fabricated adjacent to the base dies such that the vias are laterally adjacent to the base dies and extend across an entire thickness of the base dies. The fabricated vias will become a part of a power routing to a backside metallization of one or more IC dies, as discussed herein.

FIG. 21 illustrates a cross-sectional side view of a device structure 2100 similar to device structure 2000 after removal of substrate 1901, and after formation of a dielectric material 2101 laterally adjacent to base die 102. For example, dielectric material 2101 may be formed over and around base die 102 such that base die 102 is embedded in dielectric material 2101, and backside material operation(s) may be performed to remove substrate 1901 and portions of dielectric material 2101. Alternatively, dielectric material 2101 may be applied after removal of substrate 1901, which is followed by planarization operation(s). Dielectric material 2101 may be any material discussed with respect to dielectric material 1701. As shown, a substantially planar surface 2102 of device structure 2100 is exposed for die attachment. In the illustrated embodiment, optional substrate layer 142 remains and is exposed, however, in some embodiments, frontside metallization 140 is exposed.

FIG. 22 illustrates a cross-sectional side view of a device structure 2200 similar to device structure 2100 after fabrication of vias 110, which may be characterized as through dielectric vias. Vias 110 may be fabricated using any suitable technique or techniques. In some embodiments, openings or holes are formed in dielectric material 2101 using lithography and etch techniques, laser drilling techniques, or other patterning techniques. The resultant openings or holes may then be filled with conductive material using deposition and/or plating techniques, which may be followed by planarization operations to restore substantially planar surface 2102. As shown, vias 110 are laterally adjacent to base die 102 (i.e., in the x-y plane) and extend vertically (i.e., in the z-direction) across a full thickness of base die 102. Thereby, power routing can bypass base die 102 using vias 110.

Returning to FIG. 14, processing continues from operations 1403 and 1405 at operation 1406, where the IC dies formed at operation 1403 are mounted to the reconstituted base die wafer formed at operation 1405. Although discussed with respect to IC dies being mounted to a reconstituted base die wafer, methods 1400 may be used to form diced base dies (including adjacent dielectric material and through dielectric vias) that are mounted to a reconstituted IC die wafer. In other embodiments, wafer to wafer bonding may be used. At operation 1405, singulated IC dies may be mounted to the reconstituted base die wafer using any suitable technique or techniques such as hybrid bonding techniques.

For example, the metal patterning of the surfaces of the IC dies and the base wafer are matched metal to metal and dielectric to dielectric for hybrid bonding. Such surface may then be brought together optionally under pressure and/or heat to meld the metal to form die level interconnects and, optionally, to meld the dielectric material to form the hybrid bond. Although discussed with respect to hybrid bonding for die level interconnects, other interconnect techniques and structures may be used such as solder bonding using solder balls or similar features.

FIG. 23 illustrates a cross-sectional side view of a device structure 2300 similar to device structure 2200 after bonding a number of IC die(s) 101 and VR die(s) to substantially planar surface 2102. As discussed, such bonding may be performed using any suitable technique or techniques such as hybrid bonding, solder interconnects, or the like. Such die level interconnects are not shown in detail in FIG. 23 for the sake of clarity of presentation. By mounting IC die(s) 101 and VR die(s) to substantially planar surface 2102, any number of multichip composite device 100 or die complexes may be formed over carrier wafer 2001. Additional fabrication operations may be performed, and such multichip composite devices 100 or die complexes may subsequently be diced or singulated from carrier wafer 2001. Notably, in device structure 2300, backside metallization 134 is exposed at the top of device structure 2300 for bonding to a metallization network.

Returning to FIG. 14, processing continues at operation 1407, where a metallization network is formed over the IC dies mounted at operation 1406. In some embodiments, the metallization network is formed on a separate metallization die or dies and the metallization die or dies are mounted to the exposed backside metallizations of the mounted IC dies. In some embodiments, the metallization network is formed directly over the exposed backside metallizations of the mounted IC dies. For example, the metallization network may be formed using screen printing techniques or other additive metallization techniques as discussed with respect to FIG. 10. In some embodiments, the metallization network is formed by wire bonding between IC die(s) and adjacent ones of the IC die(s) and/or adjacent VR dies or components. In some embodiments, such wire bonding may be used to fabricate an inductor by embedding a wire bond in magnetic material such as a magnetic mold material. For example, the metallization network may be formed of wire bonds embedded in a dielectric or magnetic material such as a magnetic mold material as discussed with respect to FIG. 13.

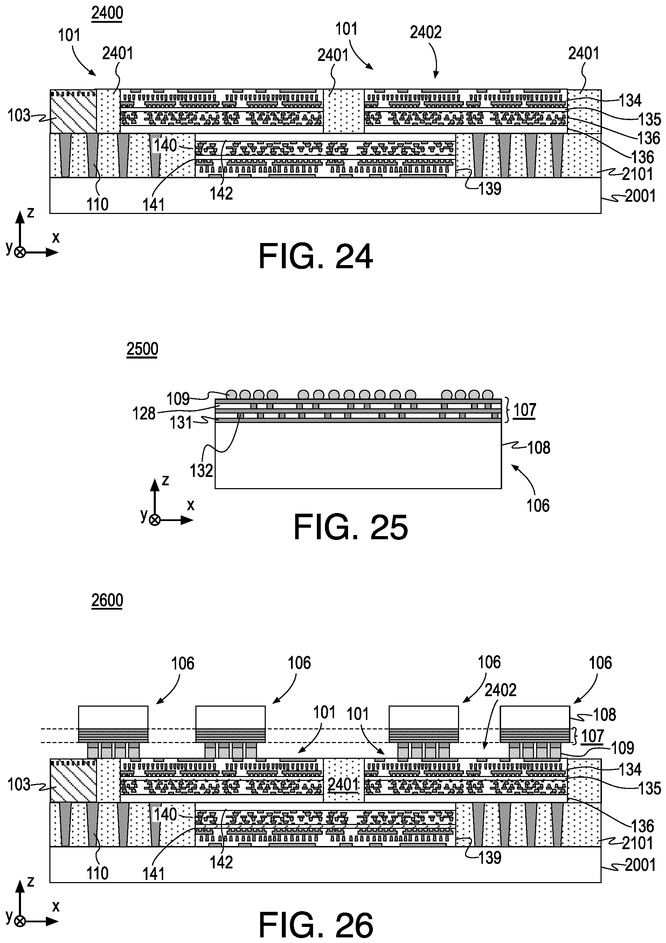

FIG. 24 illustrates a cross-sectional side view of a device structure 2400 similar to device structure 2300 after removal of the remaining portions of carrier wafer 1601, and after formation of a dielectric material 2401 laterally adjacent to IC die(s) 101 and VR die(s) 103. For example, dielectric material 2401 may be formed over and around IC die(s) 101 and VR die(s) 103 such that IC die(s) 101 and VR die(s) 103 are embedded in dielectric material 2401, and backside material operation(s) may be performed to remove remaining portions of carrier wafer 1601 and portions of dielectric material 2401. Alternatively, dielectric material 2401 may be applied after removal of the remaining portions of carrier wafer 1601, which is followed by planarization operation(s). Dielectric material 2401 may be any material discussed with respect to dielectric material 1701. As shown, a substantially planar surface 2402 of device structure 2400 is exposed for formation of a metallization network. Notably, backside metallizations 134 of IC dies 101 are exposed such that the metallization network may be formed proximal to backside metallizations 134.

FIG. 25 illustrates a cross-sectional side view of fabrication 2500 of metallization die 106. Metallization die 106 includes a substrate 108 and metallization levels 131, via levels 132, and dielectric material 128 are formed over substrate 108 using any suitable technique or techniques. In some embodiments, metallization levels 131, via levels 132, and dielectric material 128 are formed using damascene or dual damascene approaches. In some embodiments, metallization levels 131, via levels 132, and dielectric material 128 are formed using additive bulk metallization processing followed by patterning. as shown, interconnects 109 may be formed on or over metallization network 107.

FIG. 26 illustrates a cross-sectional side view of a device structure 2600 similar to device structure 2400 after bonding a number of metallization die(s) 106 to substantially planar surface 2402. Such bonding may be performed using any suitable technique or techniques such as solder interconnects, hybrid bonding, or the like. In the context of FIG. 26, multiple metallization die(s) 106 are deployed to form metallization network 107. In some embodiments, one or more of metallization die(s) 106 are interconnected across IC die(s) 101 and VR die(s) 103 (i.e., interconnect separate dies) and one or more of metallization die(s) 106 are intra-connected within an individual one of IC die(s) 101 and VR die(s) 103. In some embodiments, metallization network 107 is formed by mounting a single metallization die 106 for each multichip composite device 100 or die complex, as illustrated herein above (refer to FIG. 1). In some embodiments, a single one metallization die 106 may span across (e.g., in the x-y plane) each of VR die(s) 103 and IC dies 101 to couple to each of VR die(s) 103 and IC dies 101. In some embodiments, a single one metallization die 106 may span across the entire lateral area covered by the metallization dies 106, or an even greater lateral such as the entirety of the region illustrated in FIG. 26, or more.

Device structure 2600 illustrates formation of metallization network 107 using one or more metallization die(s) 106 such that metallization network 107 or portions thereof are formed on a separate metallization die(s) 106, and metallization die(s) 106 are mounted over the exposed backside metallizations 134 of IC dies 101. In some embodiments, metallization network 107 is formed directly over exposed backside metallizations 134 of IC dies 101. With reference to FIG. 10, metallization network 107 may be formed using screen printing techniques or other additive metallization techniques to directly apply metallization network 107 to substantially planar surface 2402. In some embodiments, metallization network 107 is formed of wire bonds by wire bonding processing. With reference to FIG. 13, metallization network 107 may be formed of bond wires 1301, which are fabricated using any suitable technique or techniques to interconnect IC die(s) 101 and VR die(s) 103 over substantially planar surface 2402.

Furthermore, device structure 2600 illustrates vias 110 laterally adjacent to base die 102 and extending vertically across the thickness of base die 102 to VR die 103. In some embodiments, VR dies 103 are not used, and, in such contexts vias 110 are laterally adjacent to base die 102 and IC die(s) 101 (i.e., in the x-y plane) and extend vertically (i.e., in the z-direction) across a full thickness established by base die 102 and IC die(s) 101. Thereby, power routing can bypass base die 102 and IC die(s) 101 and couple directly to metallization network 107. Such vias may be formed within device structure 2400, as discussed with respect to FIG. 22, for example. In some embodiments, openings or holes are formed in dielectric material 2401 and dielectric material 2101 using lithography and etch techniques, laser drilling techniques, or other patterning techniques, and the openings or holes are filled with conductive material using deposition and/or plating techniques, which may be followed by planarization operations to restore substantially planar surface 2402.

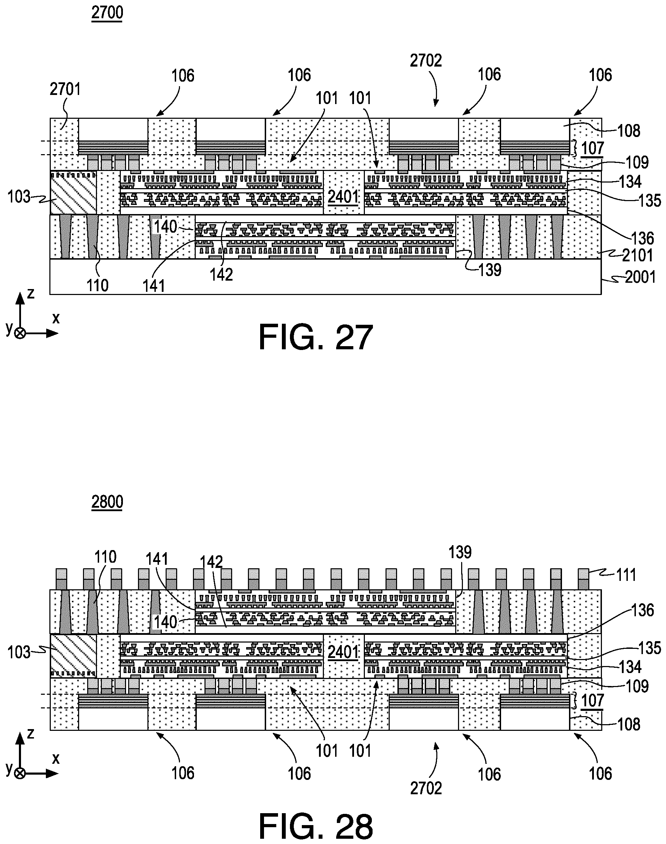

FIG. 27 illustrates a cross-sectional side view of a device structure 2700 similar to device structure 2600 after formation of a dielectric material 2701 laterally adjacent to metallization die(s) 106. For example, dielectric material 2701 may be formed over and around metallization die(s) 106 such that metallization die(s) 106 are embedded in dielectric material 2701, and backside material operation(s) may be performed to remove portions of dielectric material 2701 and form a substantially planar surface 2702. In some embodiments, all or portions of substrate 108 may be removed. For example, the backside material operation(s) may also remove remaining substrate 108. Alternatively, dielectric material 2701 may be applied after removal of substrate 108, which is followed by planarization operation(s). Dielectric material 2701 may be any material discussed with respect to dielectric material 1701. Substantially planar surface 2702 of device structure 2700 may be used to mount a heat removal device as illustrated herein.

Returning to FIG. 14, processing continues at operation 1408, where the carrier wafer hosting the base dies, IC dies and/or VR dies, and metallization network is removed, and package level interconnects are formed. In some embodiments, the die complex structures provide enough structure support for package level interconnects and deployment of another carrier wafer or support substrate is not needed during such processing. However, an additional carrier wafer proximal to the metallization network can be used. The carrier wafer may be removed using any suitable technique or techniques such as UV or heat release, when UV- or heat-releasable adhesives are used, grind or chemical removal operations, or the like. The package level interconnects are then formed using any suitable technique or techniques such as solder ball pick and place and reflow, or similar operations. Although illustrated with respect to solder-based package level interconnects, any suitable interconnects such as copper posts may be used.

FIG. 28 illustrates a cross-sectional side view of a device structure 2800 similar to device structure 2700 after removal of carrier wafer 2001, and after formation of interconnects 111. Notably, device structure 2800 is flipped relative to device structure 2700. As discussed, carrier wafer 2001 may be removed by application of UV light and/or heat release, mechanical operations such as grinding, and/or chemical removal operations, or the like. Interconnects 111 are then formed on or over vias 110 and frontside metallization 140 using any suitable technique or techniques such solder formation, bond pad and solder formation, or the like. In some embodiments, a carrier wafer or panel (not shown) is under substantially planar surface 2702 for added support, particularly in embodiments where substrate 108 is removed.

Returning to FIG. 14, processing continues at operation 1409, where the fabricated multichip composite devices or die complexes are singulated, tested, and packaged. Such testing may be performed before or after singulation, and such multichip composite devices or die complex testing may be performed using any suitable technique or techniques such as coupling probe pins to conductive pads probing (using test circuitry) various pathways and components of the multichip composite devices or die complexes. Those that pass test are passed along for continued processing, as is known in the art. Such processing may include dicing, packaging, assembly, and so on. The resultant device (e.g., packaged multichip composite devices or die complexes) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

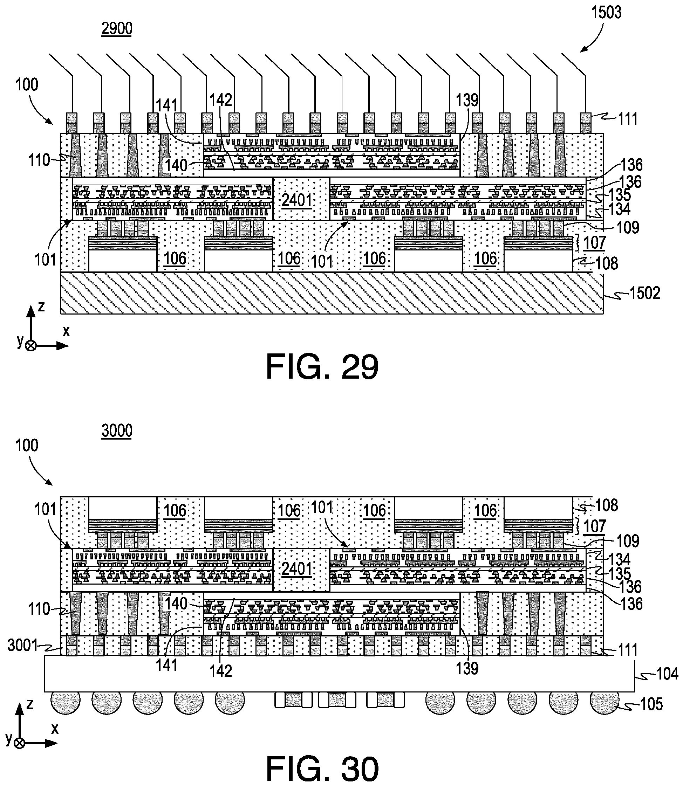

FIG. 29 illustrates a cross-sectional side view of multichip composite device 100 under test 2900. IC die 101 includes or is attached to a substrate 1501. IC die 101 further includes frontside metallization 136, device layer 135, backside metallization 134, and optional substrate layer 137. As shown, IC die 101 may be attached or mounted to a thermal head 1502, which provides temperature control and optional temperature stressing during test. Probe pins 1503 are coupled to backside metallization 134 and are used to test various components of IC die 101 such as active or test components of device layer 135.

FIG. 30 illustrates a cross-sectional side view of a device structure 3000 similar to device structure 2800 after singulation or dicing to separate out multichip composite device 100 and mounting multichip composite device 100 to microelectronics substrate 104. Multichip composite device 100 may be mounted and electrically coupled to microelectronics substrate 104 using any suitable technique or techniques such as controlled collapse chip connection processes or the like. An underfill material 3001 may be formed around interconnects 111 to protect interconnects 111 from moisture and to provide structural support.

The multichip composite device discussed herein offer advantages in terms of power delivery, IO routing efficiency, and others. It is noted that the thermal performance of the discussed multichip composite devices may be comparable to prior structures or architectures or may have improvement based on the improved efficiency of power delivery. Other advantages will be evident based on the present disclosure.

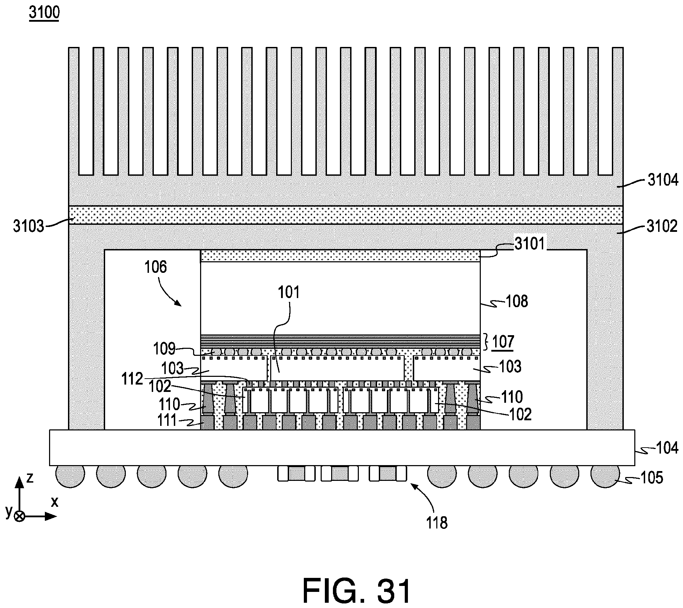

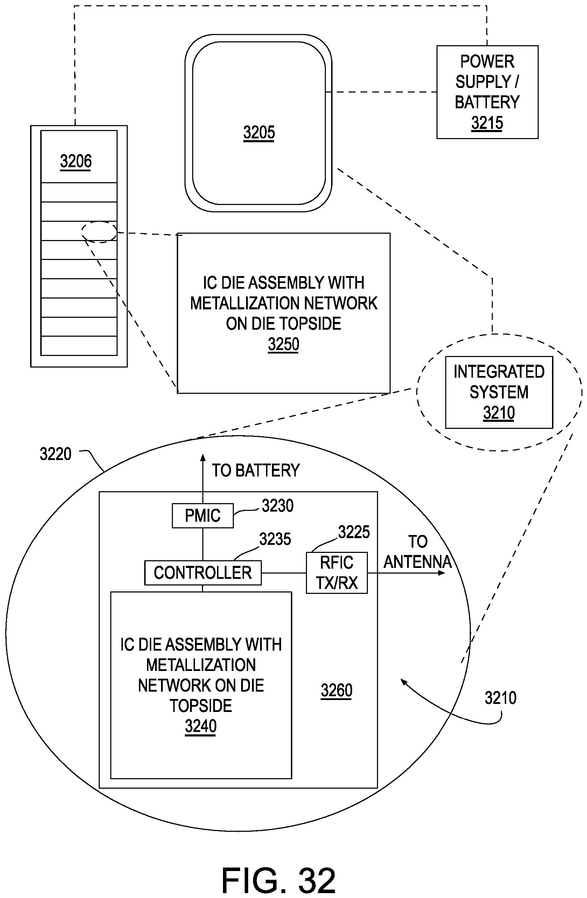

FIG. 31 illustrates an example microelectronic device assembly 3100 including multichip composite device 100 having topside metallization network 107 to provide a power route to backside 119 of integrated circuit die 101, in accordance with some embodiments. In the illustrative example of FIG. 31, multichip composite device 100 is represented. However, any multichip composite device, microelectronic device, or any other structure or architecture discussed herein may be deployed in microelectronic device assembly 3100. As shown, microelectronic device assembly 3100 includes base dies 102 attached to microelectronics substrate 104 via interconnects 111. Microelectronic device assembly 3100 further includes IC die 101 and VR dies 103 over and coupled to base dies 102 by die level interconnects 112, and metallization network 107 to provide a topside power (and, optionally, additional IO) routing to IC die 101 from microelectronics substrate 104 and through vias 110. As discussed, in some embodiments, VR dies 103 are not deployed and direct connection is made to metallization network 107 by vias 110. Furthermore, base dies 102 provide IO routing to IC die 101 such that the IO routing is through frontside metallization of IC die 101 and the topside power (and, optionally, additional IO) routing are provided through backside metallization of IC die 101. In some embodiments, the power routing is source from a power supply that may include a battery, voltage converter, power supply circuitry, or the like, as illustrated in FIG. 32.

Microelectronic device assembly 3100 further includes a thermal interface material (TIM) 3101 disposed on a top surface of, for example, substrate 108. In such embodiments, substrate 108 may act as an integrated heat spreader (IHS) for multichip composite device 100. In other embodiments, TIM 3101 may be on a mold material or dielectric, which encompasses bond wires or thick metallization, for example. TIM 3101 may include any suitable thermal interface material and may be characterized as TIM 1. Integrated heat spreader 3102, having a surface, on TIM 3101 extends over multichip composite device 100, and is mounted to microelectronics substrate 104. As discussed, microelectronics substrate 104 may include any suitable substrate such as a package substrate, motherboard, interposer, or the like. In addition or in the alternative, microelectronics substrate 104 may be mounted to a motherboard. Microelectronic device assembly 3100 further includes TIM 3103 disposed on a top surface of integrated heat spreader 3102. TIM 3103 may include any suitable thermal interface material and may be characterized as TIM 2. TIM 3101 and TIM 3103 may be the same materials or they may be different. Heat sink 3104 (e.g., an exemplary heat dissipation device or thermal solution) is on TIM 3103 and dissipates heat generated by multichip composite device 100. Although illustrated with respect to microelectronic device assembly 3100, the various multichip composite devices discussed herein may be deployed in any suitable architecture and form factor. For example, microelectronic device assembly 3100 may be used in desktop and server form factors. In other contexts, a heat solution such as a heat pipe, heat spreader, or thermoelectric cooler may be mounted directly on TIM 3101 or substrate 108 may be replaced by a solution such as a heat pipe or thermoelectric cooler. Such assemblies may be used in smaller form factor devices.

FIG. 32 illustrates exemplary systems employing an IC assembly including a multichip composite device having a topside metallization network to provide a power route to a backside of an integrated circuit die, in accordance with some embodiments. The system may be a mobile computing platform 3205 and/or a data server machine 3206, for example. Either may employ a component assembly including a multichip composite device having a topside metallization network for power delivery to an IC die backside as described elsewhere herein. Server machine 3206 may be any commercial server, for example including any number of high-performance computing platforms disposed within a rack and networked together for electronic data processing, which in the exemplary embodiment includes an IC die assembly 3250 with a multichip composite device having a topside metallization network for power delivery to an IC die backside as described elsewhere herein. Mobile computing platform 3205 may be any portable device configured for each of electronic data display, electronic data processing, wireless electronic data transmission, or the like. For example, mobile computing platform 3205 may be any of a tablet, a smart phone, a laptop computer, etc., and may include a display screen (e.g., a capacitive, inductive, resistive, or optical touchscreen), a chip-level or package-level integrated system 3210, and a battery 3215. Although illustrated with respect to mobile computing platform 3205, in other examples, chip-level or package-level integrated system 3210 and a battery 3215 may be implemented in a desktop computing platform, an automotive computing platform, an internet of things platform, or the like. As discussed below, in some examples, the disclosed systems may include a sub-system 3260 such as a system on a chip (SOC) or an integrated system of multiple ICs, which is illustrated with respect to mobile computing platform 3205.

Whether disposed within integrated system 3210 illustrated in expanded view 3220 or as a stand-alone packaged device within data server machine 3206, sub-system 3260 may include memory circuitry and/or processor circuitry 3240 (e.g., RAM, a microprocessor, a multi-core microprocessor, graphics processor, etc.), a power management integrated circuit (PMIC) 3230, a controller 3235, and a radio frequency integrated circuit (RFIC) 3225 (e.g., including a wideband RF transmitter and/or receiver (TX/RX)). As shown, one or more IC dies, such as memory circuitry and/or processor circuitry 3240 may be assembled and implemented such that one or more have a multichip composite device having a topside metallization network for power delivery to an IC die backside as described herein. In some embodiments, RFIC 3225 includes a digital baseband and an analog front end module further comprising a power amplifier on a transmit path and a low noise amplifier on a receive path). Functionally, PMIC 3230 may perform battery power regulation, DC-to-DC conversion, etc., and so has an input coupled to battery 3215, and an output providing a current supply to other functional modules. As further illustrated in FIG. 32, in the exemplary embodiment, RFIC 3225 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 3240 may provide memory functionality for sub-system 3260, high level control, data processing and the like for sub-system 3260. In alternative implementations, each of the SOC modules may be integrated onto separate ICs coupled to a package substrate, interposer, or board.

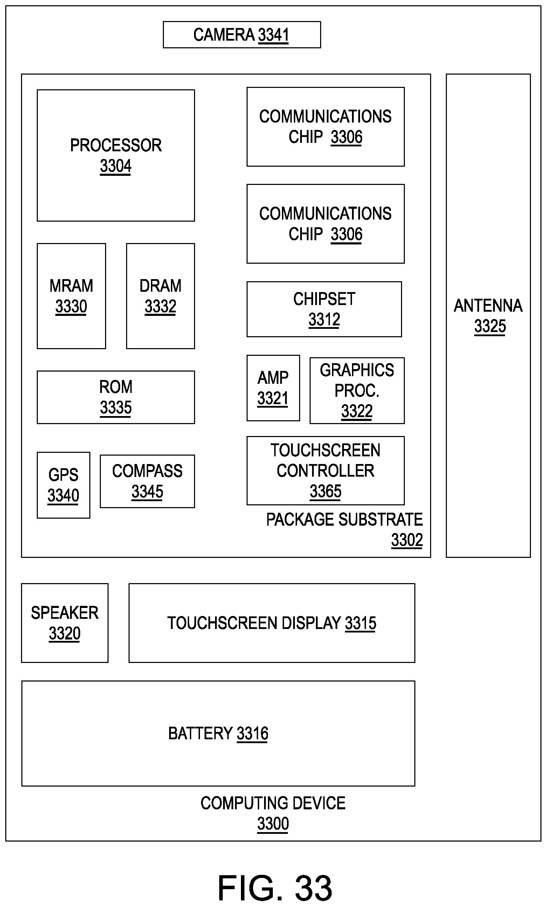

FIG. 33 is a functional block diagram of an electronic computing device 3300, in accordance with some embodiments. For example, device 3300 may, via any suitable component therein, employ a multichip composite device having a topside metallization network for power delivery to an IC die backside in accordance with any embodiments described elsewhere herein. Device 3300 further includes a motherboard or package substrate 3302 hosting a number of components, such as, but not limited to, a processor 3304 (e.g., an applications processor). Processor 3304 may be physically and/or electrically coupled to package substrate 3302. In some examples, processor 3304 is within an IC assembly that includes a multichip composite device having a topside metallization network for power delivery to an IC die backside as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 3306 may also be physically and/or electrically coupled to the package substrate 3302. In further implementations, communication chips 3306 may be part of processor 3304. Depending on its applications, computing device 3300 may include other components that may or may not be physically and electrically coupled to package substrate 3302. These other components include, but are not limited to, volatile memory (e.g., DRAM 3332), non-volatile memory (e.g., ROM 3335), flash memory (e.g., NAND or NOR), magnetic memory (MRAM 3330), a graphics processor 3322, a digital signal processor, a crypto processor, a chipset 3312, an antenna 3325, touchscreen display 3315, touchscreen controller 3365, battery 3316, audio codec, video codec, power amplifier 3321, global positioning system (GPS) device 3340, compass 3345, accelerometer, gyroscope, speaker 3320, camera 3341, and mass storage device (such as hard disk drive, solid-state drive (SSD), compact disk (CD), digital versatile disk (DVD), and so forth, or the like.

Communication chips 3306 may enable wireless communications for the transfer of data to and from the computing device 3300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 3306 may implement any of a number of wireless standards or protocols, including, but not limited to, those described elsewhere herein. As discussed, computing device 3300 may include a plurality of communication chips 3306. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example the above embodiments may include specific combinations of features as further provided below.

The following pertains to exemplary embodiments.

In one or more first embodiments, an apparatus comprises an integrated circuit die over and coupled to a base die, the integrated circuit die comprising a device layer between a first stack of metallization layers and a second stack of metallization layers, the first stack of metallization layers proximal to the base die and having more metallization layers than the second stack of metallization layers, a metallization network over the integrated circuit die and coupled to the second stack of metallization layers, the metallization network comprising one or more metallization layers each having a thickness of not less than five times a thickness of any of the first or second stack of metallization layers, and a via laterally adjacent to the base die, the via coupled to the metallization network.

In one or more second embodiments, further to the first embodiments, the apparatus further comprises a metallization die comprising a substrate and the metallization network, such that the substrate comprises silicon and the metallization network comprises metal traces embedded in an inorganic dielectric material.

In one or more third embodiments, further to the first or second embodiments, apparatus further comprises a voltage regulator between the via and the metallization network.

In one or more fourth embodiments, further to the first through third embodiments, the base die comprises a plurality of through vias, the via, the voltage regulator, and the metallization network comprise a power route to the second stack of metallization layers, and the through vias comprise an input/output route to the first stack of metallization layers.

In one or more fifth embodiments, further to the first through fourth embodiments, apparatus further comprises a second integrated circuit die over and coupled to the base die, the second integrated circuit die laterally adjacent to the integrated circuit die, such that metallization network comprises a signal path between the integrated circuit die and the second integrated circuit die.

In one or more sixth embodiments, further to the first through fifth embodiments, apparatus further comprises a second integrated circuit die directly coupled to the metallization network, such that the second integrated circuit die comprises a second device layer between a third stack of metallization layers and a fourth stack of metallization layers, the third stack of metallization layers adjacent to the metallization network and having fewer metallization layers than the fourth stack of metallization layers.

In one or more seventh embodiments, further to the first through sixth embodiments, the metallization network has an overall thickness and the apparatus further comprises a component in contact with the metallization network and within the overall thickness of the metallization network.

In one or more eighth embodiments, further to the first through seventh embodiments, the metallization network comprises one of a plurality substantially planar metal lines or a plurality of wire bonds.

In one or more ninth embodiments, further to the first through eighth embodiments, the thickest metallization layer of the first stack of metallization layers has a first thickness less than a second thickness of the thinnest metallization layer of the second stack of metallization layers.

In one or more tenth embodiments, further to the first through ninth embodiments, each metallization layer of the metallization network has thickness of not less than ten times a thickness of any of the first or second stack of metallization layers.

In one or more eleventh embodiments, further to the first through tenth embodiments, apparatus further comprises a microelectronics board, such that the via and the base die are mounted to the microelectronics board.

In one or more twelfth embodiments, a system comprises an integrated circuit package according to any of the apparatuses of the first through tenth embodiments, and a microelectronics board coupled to the integrated circuit package

In one or more thirteenth embodiments, an apparatus comprises an integrated circuit die over and coupled to a base die, the integrated circuit die comprising a device layer between frontside metallization and backside metallization, the frontside metallization proximal to the base die, a metallization network over the integrated circuit die and coupled to the backside metallization, a via laterally adjacent to the base die, the via coupled to the metallization network and extending to an external interconnect.

In one or more fourteenth embodiments, further to the thirteenth embodiments, the apparatus further comprises a metallization die comprising a substrate and the metallization network, such that the substrate comprises silicon and the metallization network comprises metal traces embedded in an inorganic dielectric material.

In one or more fifteenth embodiments, further to the thirteenth or fourteenth embodiments, the apparatus further comprises a voltage regulator between the via and the metallization network, such that the base die comprises a plurality of through vias, the via, the voltage regulator, and the metallization network comprising a power route to the backside metallization, and the through vias comprising an input/output route to the frontside metallization.

In one or more sixteenth embodiments, further to the thirteenth through fifteenth embodiments, the apparatus further comprises a second integrated circuit die directly coupled to the metallization network, such that the second integrated circuit die comprises a second device layer between a third stack of metallization layers and a fourth stack of metallization layers, the third stack of metallization layers adjacent to the metallization network and having fewer metallization layers than the fourth stack of metallization layers.

In one or more seventeenth embodiments, further to the thirteenth through sixteenth embodiments, the apparatus further comprises a microelectronics board, such that the via and the base die are mounted to the microelectronics board.

In one or more eighteenth embodiments, a system comprises an integrated circuit package according to any of the apparatuses of the thirteenth through sixteenth embodiments, and a microelectronics board coupled to the integrated circuit package.

In one or more nineteenth embodiments, a method comprises mounting a first die to a second die, the first die comprising a device layer between frontside metallization layers and backside metallization layers, wherein the frontside metallization layers of the first die are mounted proximal to the second die, forming a via laterally adjacent to the second die, and forming a metallization network over and proximal to the backside metallization layers of the first die, the metallization network coupled to the via and the metallization network comprising one or more metallization layers each having thickness of not less than five times a thickness of any metallization layer of the frontside metallization layers and the backside metallization layers.

In one or more twentieth embodiments, further to the nineteenth embodiments, mounting the first die to the second die comprises one of placing the first die on a first reconstituted wafer comprising the second die or placing the second die on a second reconstituted wafer comprising the first die.

In one or more twenty-first embodiments, further to the nineteenth or twentieth embodiments, forming the metallization network comprises one of wire bonding the second die to an adjacent third die, directly applying the metallization network to the second die, or placing a metallization die comprising a substrate and the metallization network on the second die.

In one or more twenty-second embodiments, further to the nineteenth through twenty-first embodiments, said mounting the first die to the second die comprises hybrid bonding the first die to the second die and wherein said forming the metallization network comprises solder bump bonding a metallization die comprising a substrate and the metallization network to the second die.

However, the above embodiments are not limited in this regard, and in various implementations, the above embodiments may include the undertaking of only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
an integrated circuit die over and coupled to a base die, the integrated circuit die comprising a device layer between a first stack of metallization layers and a second stack of metallization layers, the first stack of metallization layers proximal to the base die and having more metallization layers than the second stack of metallization layers;
a metallization network over the integrated circuit die and coupled to the second stack of metallization layers, the metallization network comprising one or more metallization layers each having a thickness of not less than five times a thickness of any of the first or second stack of metallization layers; and
a via laterally adjacent to the base die, the via coupled to the metallization network.

2. The apparatus of claim 1, further comprising:
a metallization die comprising a substrate and the metallization network, wherein the substrate comprises silicon and the metallization network comprises metal traces embedded in an inorganic dielectric material.

3. The apparatus of claim 1 or 2, further comprising:
a voltage regulator between the via and the metallization network.

4. The apparatus of claim 3, wherein the base die comprises a plurality of through vias, wherein the via, the voltage regulator, and the metallization network comprise a power route to the second stack of metallization layers, and wherein the through vias comprise an input/output route to the first stack of metallization layers.

5. The apparatus of any of claims 1 to 4, further comprising:
a second integrated circuit die over and coupled to the base die, the second integrated circuit die laterally adjacent to the integrated circuit die, wherein metallization network comprises a signal path between the integrated circuit die and the second integrated circuit die.

6. The apparatus of any of claims 1 to 5, further comprising:
a third integrated circuit die directly coupled to the metallization network, wherein the third integrated circuit die comprises a second device layer between a third stack of metallization layers and a fourth stack of metallization layers, the third stack of metallization layers adjacent to the metallization network and having fewer metallization layers than the fourth stack of metallization layers.

7. The apparatus any of claims 1 to 6, wherein the metallization network has an overall thickness, the apparatus further comprising:
a component in contact with the metallization network and within the overall thickness of the metallization network.

8. The apparatus of any of claims 1 to 7, wherein the metallization network comprises one of a plurality substantially planar metal lines or a plurality of wire bonds.

9. The apparatus of any of claims 1 to 8, wherein the thickest metallization layer of the first stack of metallization layers has a first thickness less than a second thickness of the thinnest metallization layer of the second stack of metallization layers.

10. The apparatus of claim 9, wherein each metallization layer of the metallization network has thickness of not less than ten times a thickness of any of the first or second stack of metallization layers.

11. The apparatus of any of claims 1 to 10, further comprising:
a microelectronics board, wherein the via and the base die are mounted to the microelectronics board.

12. A method, comprising:
mounting a first die to a second die, the first die comprising a device layer between frontside metallization layers and backside metallization layers, wherein the frontside metallization layers of the first die are mounted proximal to the second die;
forming a via laterally adjacent to the second die; and
forming a metallization network over and proximal to the backside metallization layers of the first die, the metallization network coupled to the via and the metallization network comprising one or more metallization layers each having thickness of not less than five times a thickness of any metallization layer of the frontside metallization layers and the backside metallization layers.

13. The method of claim 12, wherein said mounting the first die to the second die comprises one of placing the first die on a first reconstituted wafer comprising the second die or placing the second die on a second reconstituted wafer comprising the first die.

14. The method of claim 12 or 13, wherein forming the metallization network comprises one of wire bonding the second die to an adjacent third die, directly applying the metallization network to the second die, or placing a metallization die comprising a substrate and the metallization network on the second die.

15. The method of any of claims 12 to 14, wherein said mounting the first die to the second die comprises hybrid bonding the first die to the second die and wherein said forming the metallization network comprises solder bump bonding a metallization die comprising a substrate and the metallization network to the second die.
